# EUROPEAN PATENT SPECIFICATION

(11) **EP 2 727 972 B1**
(45) Date of publication and mention of the grant of the patent: **01.11.2017**
(21) Application number: 12804382.5
(22) Date of filing: 27.06.2012
(51) Int. Cl.: C09J 123/22, C08L 23/22, C09J 7/02, C09J 7/00, C09J 201/00, H01L 51/50, H05B 33/04, C09J 123/20, C09K 3/10, C08L 23/20, H01L 51/52

(54) **ADHESIVE COMPOSITION AND ADHESIVE SHEET**
HAFTZUSAMMENSETZUNG UND HAFTFOLIE
COMPOSITION ADHÉSIVE ET FEUILLE ADHÉSIVE

(30) Priority: 28.06.2011 JP 2011142853; 06.07.2011 JP 2011149894
(43) Date of publication of application: 07.05.2014
(73) Proprietor: Lintec Corporation, Tokyo 173-0001 (JP)
(72) Inventor: UEMURA, Kazue, Tokyo 173-0001 (JP); ONO, Yoshitomo, Tokyo 173-0001 (JP); AMINO, Yumiko, Tokyo 173-0001 (JP); KAWADA, Satoshi, Tokyo 173-0001 (JP); IKEDA, Hanako, Tokyo 173-0001 (JP)
(74) Representative: Gille Hrabal
(86) International application number: PCT/JP2012/066438
(87) International publication number: WO 2013/002288

(56) References cited:
- EP-A1- 2 615 144
- WO-A1-2011/062167
- WO-A1-2012/032907
- WO-A2-2009/148722
- JP-A- 9 221 649
- JP-A- 2009 524 705
- JP-A- 2010 072 471
- JP-A- 2011 132 522
- JP-A- 2011 231 313

## Description

### TECHNICAL FIELD

The present invention relates to an adhesive composition and an adhesive sheet, and more precisely relates to an adhesive composition and an adhesive sheet favorably usable for sealing up electronic devices, for example, display devices and the like, such as organic EL devices and others that utilize electroluminescence (hereinafter this may be abbreviated as "EL") of organic material.

### BACKGROUND ART

Recently, organic electronics has become specifically noted as a technique of forming displays, circuits, batteries and the like on a flexible plastic substrate at a low temperature close to room temperature by using a coating or printing process, and studies and developments of various organic devices, liquid-crystal displays, electronic papers, thin-film transistors and others are being promoted.

For example, an organic EL element for use in organic devices is one produced by providing organic layers of an organic charge transport layer and an organic light-emitting layer as laminated between an anode and a cathode, and is specifically noted as a light-emitting element that enables high-intensity light emission through low-voltage direct-current drive. In addition, an organic EL element uses a plastic film as the substrate therein and is therefore expected to be a display capable of realizing thinning, weight-saving, flexibleness, etc.

However, an organic EL element has a problem in that, when driven for a certain period of time, the light-emitting characteristics thereof, such as brightness, luminescence efficiency, emission uniformity and the like would lower than the initial ones. Reasons of the problem would be because of oxidation of electrodes and degradation of organic matters by oxygen, moisture vapor and the like having penetrated into the organic EL element, and of oxidative decomposition of organic materials by heat during driving, etc.

As the case may be, owing to influence of oxygen and moisture (water vapor), heat generation during driving and exposure to high temperatures during driving, stress may occur in the interface of the structure of an organic EL element due to difference in thermal expansion between the constitutive components of the structure, and there may occur interfacial peeling in the structure. Such mechanical degradation of structure would also be a cause of degradation of light-emitting characteristics.

For sealing up an organic EL element to prevent it from being kept in contact with oxygen and moisture (water vapor) for the purpose of preventing the problems, for example, techniques described in the following PTL 1 to 4 have been proposed.

PTL 1 discloses a method of coating the organic EL layer formed on a glass substrate with a moisture-resistant photocurable resin and fixing a poorly moisture-permeable substrate on the top of the photocurable resin layer.

PTL 2 discloses a method of sealing up facing transparent substrates with a sealing material of frit glass.

PTL 3 discloses a method of bonding the two with a cationic UV-curable epoxy resin adhesive agent, in forming an airtight space between a substrate and a shield.

PTL 4 discloses a method of coating the outer surface of an organic EL element with a sealing film formed of a moisture-proof polymer film and an adhesive layer.

However, according to the above-mentioned conventional techniques, the organic light-emitting layer and the charge transport layer may be thermally degraded owing to heating in the sealing step, and use of the photocurable resin adhesive agent requires a large quantity of UV irradiation for curing and therefore the organic light-emitting layer and the charge transport layer would be degraded. In addition, when the sealing material is a cured product, the product would be cracked owing to impact or vibration given thereto during use and the element characteristics would be thereby degraded. Further in PTL 4, the adhesion force and the retention force are insufficient for use as the sealing material and the method does not satisfy the demand level of moisture-resistance and moisture-proofness.

PTL 5 discloses, for the purpose of solving the above-mentioned problems, an adhesive sealing composition for use in electronic devices, which comprises a hydrogenated cyclic olefin-based polymer and a polyisobutylene-based resin having a weight-average molecular weight of 500,000 or more.

PTL 6 provides an adhesive encapsulating composition for use in an electronic device, comprising: a first polyisobutylene resin having a weight average molecular weight of greater than about 300,000 g/mol; and a second polyisobutylene resin having a weight average molecular weight of less than about 100,000 g/mol, wherein the adhesive encapsulating composition is substantially free of tackifier.

### CITATION LIST

### PATENT LITERATURE

- PTL 1:: JP-A-5-182759
- PTL 2:: JP-A-10-74583
- PTL 3:: JP-A-10-233283
- PTL 4:: JP-A-5-101884
- PTL 5:: JP-A-2007-197517
- PTL 6:: WO 2009/148722 A2

### SUMMARY OF THE INVENTION

### TECHNICAL PROBLEM

However, the adhesive sealing composition that uses a polyisobutylene-based resin, as described in PTL 5, is insufficient in point of the effect of preventing moisture vapor penetration for use for sealing up organic EL elements and others and is, in addition, poor in the balance between the adhesion force and the retention force. Further, the composition is poorly resistant to high-temperature environments and UV irradiation, and therefore when the organic EL element and device are driven for a long period of time or are exposed to high-temperature environments or UV irradiation in driving environments, then the resin has a risk of degradation of itself. As a result, the adhesive film described in PTL 5 causes degradation of the properties thereof such as adhesion force, retention force and water vapor penetration prevention, therefore having a problem of causing degradation of organic EL devices with that.

In addition, the adhesive sheet for sealing use is required to have the properties of preventing zipping generation and reducing outgas generation amount.

The present invention is to provide an adhesive composition capable of being an adhesive sheet having excellent adhesion force and retention force, capable of preventing zipping generation, having a low moisture vapor transmission rate, excellent in transparency and capable of reducing outgas generation amount, and to provide such an adhesive sheet.

### SOLUTION TO PROBLEM

The present inventors have found that the above-mentioned problems can be solved by the first invention and the second invention.

The first invention relates to an adhesive composition (hereinafter this may be referred to as "adhesive composition (I)") as described in our claim 1 as well as a further advantageous embodiment according to our claim 2.

The second invention relates to an adhesive sheet (hereinafter this may be referred to as "adhesive sheet (II)") as described in our claim 3, 4 and subsequent dependent claims thereafter.

### ADVANTAGEOUS EFFECTS OF THE INVENTION

The adhesive sheet of the present invention has excellent adhesion force and retention force, can prevent zipping generation, has a low moisture vapor transmission rate, is excellent in transparency, and can reduce out gas generation amount and, for example, can prevent degradation of the characteristics of elements sealed up with the sheet.

### BRIEF DESCRIPTION OF THE DRAWINGS

[Fig. 1] Fig. 1 shows examples of configuration of the adhesive sheet of the present invention.
[Fig. 2] Fig. 2 shows one example of an organic device having the adhesive sheet of the present invention.
[Fig. 3] Fig. 3 shows a relationship between the voltage and the brightness of the organic EL element sealed up with the adhesive sheet of the present invention or with glass.
[Fig. 4] Fig. 4 shows a probe tack, as measured according to a predetermined method, of the adhesive sheet produced in Example 1b.

### MODES FOR CARRYING OUT THE INVENTION

In the present invention, "weight-average molecular weight (Mw)" is a polystyrene-equivalent value measured according to a method of gel permeation chromatography (GPC), and concretely, this is a value measured based on the method described in the section of Examples. "Softening point" is a value measured according to JIS K2531.

### [First Invention]

The first aspect of the present invention relates to an adhesive composition (I) comprising a polyisobutylene-based resin (A) having a weight-average molecular weight of from 270,000 to 480,000 (hereinafter this may be referred to as "polyisobutylene-based resin (A)" or "resin (A)"), a polyisobutylene-based resin (B) having a weight-average molecular weight of from 100,000 to 250,000 (hereinafter this may be referred to as "polyisobutylene-based resin (B)" or "resin (B)"), and a hydrogenated petroleum resin (C) having a softening point of from 90 to 135°C (hereinafter this may be referred to as "hydrogenated petroleum resin (C)"), and to an adhesive sheet (I) having an adhesive layer of the adhesive composition (I).

### [First Invention: Adhesive Composition (I)]

The components (A) to (C) and other components to be contained in the adhesive composition (I) of the first aspect of the present invention are described in detail hereinunder.

### <Polyisobutylene-based Resin (A)>

The polyisobutylene-based resin (A) to be contained in the adhesive composition (I) of the present invention has a weight-average molecular weight of from 270,000 to 480,000. Containing the polyisobutylene-based resin (A) having a specific weight-average molecular weight, the durability and the weather resistance of the adhesive sheet can be improved and the moisture vapor transmission rate thereof can be lowered.

Regarding the structure thereof, the polyisobutylene-based resin (A) has a polyisobutylene skeleton in the main chain or in the side chain thereof, and has the following structural unit (a).

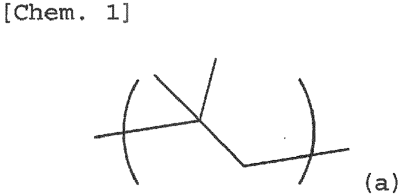

The resin (A) includes, for example, polyisobutylene as a homopolymer of isobutylene, a copolymer of isobutylene and isoprene, a copolymer of isobutylene and n-butene, a copolymer of isobutylene and butadiene, halogenobutyl rubber produced through bromination or chlorination of such a homopolymer or a copolymer, etc. One alone or two or more of such resins (A) may be used here either singly or as combined.

When the resin (A) is a copolymer, a structural unit of isobutylene shall be most of all the monomer components therein.

Of those, from the viewpoint of securing high durability and high weather resistance and of lowering the moisture vapor transmission rate thereof, preferred are ones having a dense molecular structure when polymerized and containing a structural unit of isobutylene that could not leave a polymerizing double bond in the main chain and in the side chain.

The content of the structural unit of isobutylene in the resin (A) is preferably from 80 to 100% by mass of all the structural units contained therein, more preferably from 90 to 100% by mass, even more preferably 100% by mass.

Regarding the method of producing the resin (A), there is mentioned a method of polymerizing a monomer component such as isobutylene and the like in the presence of a Lewis acid catalyst such as aluminium chloride, boron trifluoride, etc. As the resin (A), not only a synthetic one but also a commercially-available one is usable here.

The commercial product includes Vistanex (by Exxon Chemical), Hycar (by Goodrich), Oppanol (by BASF), etc.

The weight-average molecular weight of the resin (A) is, from the viewpoint of improving the cohesion force of the adhesive composition and lowering the moisture vapor transmission rate thereof, from 270,000 to 480,000, but is preferably from 300,000 to 450,000, more preferably from 320,000 to 400,000, even more preferably from 340,000 to 370,000.

When the weight-average molecular weight is smaller than 270,000, then the cohesive force of the adhesive composition could not be sufficient and the moisture vapor transmission rate would increase. If so, in addition, the composition would contaminate adherends. Basically, the resin having a higher weight-average molecular weight could lower the moisture vapor transmission rate thereof and could improve the retention force thereof.

On the other hand, when more than 480,000, the cohesion force of the adhesive composition would be too high and therefore the flexibility and the flowability thereof would be thereby worsened and the composition could not well wet adherends. If so, in addition, the solubility of the adhesive composition in solvent may lower in preparing it.

### <Polyisobutylene-based Resin (B)>

The polyisobutylene-based resin (B) to be contained in the adhesive composition (I) of the present invention has a weight-average molecular weight of from 100,000 to 250,000. Containing the polyisobutylene-based resin (B) having a specific weight-average molecular weight, the composition can provide excellent adhesion force irrespective of the type of the adherent to which it is applied, and the balance of the adhesion force and the retention force of the composition can be thereby improved.

Regarding the structure thereof, the polyisobutylene-based resin (B) has, like the resin (A), a polyisobutylene skeleton in the main chain or in the side chain thereof and has the above-mentioned structural unit (a).

As examples of the resin (B), those exemplified for the above-mentioned resin (A) can be mentioned, but from the viewpoint of securing high durability and high weather resistance and of lowering the moisture vapor transmission rate thereof, preferred are ones having a dense molecular structure when polymerized and containing a structural unit of isobutylene that could not leave a polymerizing double bond in the main chain and in the side chain.

The content of the structural unit of isobutylene in the resin (B) is preferably from 80 to 100% by mass of all the structural units contained therein, more preferably from 90 to 100% by mass, even more preferably 100% by mass.

One alone or two or more different types of the resin (B) can be used here either singly or as combined. The method for producing the resin (B) and the commercial products usable for the resin are the same as those described hereinabove in the section of the resin (A).

The resin (B) is well miscible with the resin (A) and suitably plasticizes the resin (A), thereby enhancing the wettability of the composition for adherends and improving the adhesiveness, the flexibility and the retention force thereof.

The weight-average molecular weight of the resin (B) is, from the viewpoint of securing good miscibility with the resin (A) to plasticize the resin (A) and of retarding the influence of the resin on the other physical properties such as the moisture vapor transmission rate and others of the composition, from 100, 000 to 250, 000, but preferably from 120, 000 to 230, 000, more preferably from 150,000 to 220,000, even more preferably from 180,000 to 210,000.

When the weight-average molecular weight is smaller than 100,000, then the resin (B) would have some negative influences on the physical properties of the composition in that the resin (B) would be separated as a low-molecular component to contaminate adherends, or the amount of outgas to be generated at high temperatures would increase. On the other hand, when more than 250,000, the resin could not fully plasticize the resin (A) and could not secure good wettability for adherends.

The content of the polyisobutylene resin (B) in the adhesive composition (I) is, from the viewpoint of the balance between the adhesion force and the retention force and the effect of reducing the moisture vapor transmission rate, from 5 to 55 parts by mass relative to 100 parts by mass of the resin (A), but is preferably from 7 to 40 parts by mass, more preferably from 8 to 30 parts by mass, even more preferably from 9 to 20 parts by mass.

When the content is less than 5 parts by mass, the resin (A) could not be fully plasticized and good wettability for adherends could not be provided, and therefore the adhesion force of the composition would poor. On the other hand, when more than 55 parts by mass, the cohesion force may lower and therefore the adhesion force and the retention force would be thereby lowered and the resistance to UV irradiation would be poor.

### <Hydrogenated Petroleum Resin (C)>

The hydrogenated petroleum resin (C) to be contained in the adhesive composition (I) of the present invention means a product produced by hydrogenating petroleum resin, and includes not only a completely hydrogenated resin but also a partially hydrogenated resin having a different degree of hydrogenation. In the present invention, petroleum resin means a resin derived from petroleum, and is a concept that excludes bio-derived resins, such as hydrogenated terpene resins, hydrogenated rosin and hydrogenated rosin ester resins, disproportionated rosin and disproportionated rosin ester resins, etc.

The composition contains the hydrogenated petroleum resin (C) having a softening point of from 90 to 135°C, by which the resin (A) and the resin (B) therein can be prevented from being discolored (yellowed) by high wet heat or UV ray.

The hydrogenated petroleum resin to be used in the present invention is, from the viewpoint of the miscibility thereof with the resin (A) and the resin (B), the effect thereof to lower the moisture vapor transmission rate of the composition and the resistance of the composition to high wet heat and UV ray, preferably a completely hydrogenated petroleum resin.

Concretely, the petroleum resin is preferably at least one or more selected from a group consisting of a hydrogenated resin of a C5 petroleum resin obtained through copolymerization of a C5 fraction, a hydrogenated resin of a C9 petroleum resin obtained through copolymerization of a C9 fraction, and a hydrogenated resin of a copolymerized petroleum resin of a C5 fraction and a C9 fraction.

The hydrogenated resin of a C5 petroleum resin includes a hydrogenated dicyclopentadiene-based resin, a partially hydrogenated aromatic-modified dicyclopentadiene-based resin, etc.

The above-mentioned "C5 fraction" means an unsaturated hydrocarbon having 5 carbon atoms, such as pentene, isoprene, piperine, 1,3-pentadiene and the like to be formed through thermal cracking of petroleum naphtha. "C5 petroleum resin" means a resin obtained through copolymerization of the C5 fraction and comprising the C5 fraction as the main ingredient therein (that is, containing at least 20% by mass of the fraction).

The above-mentioned "C9 fraction" means an unsaturated hydrocarbon having 9 carbon atoms, such as indene, vinyltoluene, α- or β-methylstyrene and the like to be formed through thermal cracking of petroleum naphtha. "C9 petroleum resin" means a resin obtained through copolymerization of the C9 fraction and comprising the C9 fraction as the main ingredient therein (that is, containing at least 20% by mass of the fraction).

One alone or two or more different types of the hydrogenated petroleum resin (C) may be used here either singly or as combined.

Of those, more preferred is a hydrogenated resin of a copolymerized resin of C5 fraction and C9 fraction, from the viewpoint of low moisture vapor permeability and good transparency thereof.

The softening point of the hydrogenated petroleum resin (C) to be contained in the adhesive composition (I) of the present invention is, from the viewpoint of giving excellent adhesion force to the adhesive sheet irrespective of the type of the adherend to which the sheet is applied and from the viewpoint of improving the balance between the adhesion force and the retention force of the sheet, from 90 to 135°C, but is preferably from 95 to 130°C, more preferably from 98 to 128°C, even more preferably from 105 to 120°C. When the softening point is lower than 90°C, then the adhesive composition could not have sufficient cohesion force and could not have sufficient adhesion force. On the other hand, when the softening point is higher than 135°C, then the composition could not secure sufficient adhesion force to adherends such as glass or the like and, in addition, there may occur zipping in peeling the adhesive sheet.

As the case may be, two or more different hydrogenated petroleum resins (C) each having a different softening point may be combined here to thereby enhance the adhesion force of the composition.

The content of the hydrogenated petroleum resin (C) in the adhesive composition (I) is, from the viewpoint of improving the adhesion force and the retention force irrespective of the type of adherends, from 10 to 55 parts by mass relative to 100 parts by mass of the polyisobutylene-based resin (A), but is preferably from 12 to 50 parts by mass, more preferably from 14 to 45 parts by mass, even more preferably from 16 to 35 parts by mass, still more preferably from 18 to 25 parts by mass. When the content is less than 10 parts by mass, then the power of the resin to give adhesiveness to the composition would be poor and the composition could not secure sufficient wettability for adherends and could not secure sufficient adhesion force. On the other hand, when the content is more than 55 parts by mass, then the adhesive composition could not secure sufficient cohesion force and has poor retention force so that, when bonded to an adherend, it would readily peel away. If so, in addition, the composition could not secure sufficient adhesion force especially to adherends such as glass, ITO, etc.

### <Other Additives>

Within a range not detracting from the adhesiveness thereof, the adhesive composition (I) of the present invention may contain any other additive added thereto.

The other additive includes, for example, light stabilizer, antioxidant, UV absorbent, resin stabilizer, filler, pigment, extender, etc. One alone or two or more such additives may be used here either singly or as combined.

The light stabilizer includes, for example, hindered amine-type light stabilizer, benzophenone-type light stabilizer, benzotriazole-type light stabilizer, etc.

The content of the light stabilizer is preferably from 0.01 to 2 parts by mass relative to 100 parts by mass of the resin (A).

The antioxidant includes, for example, phosphate ester compounds, etc.

The content of the antioxidant is preferably from 0.01 to 2 parts by mass relative to 100 parts by mass of the resin (A).

The UV absorbent includes, for example, benzotriazole compounds, oxazolic acid amide compounds, benzophenone compounds, etc.

The content of the UV absorbent is preferably from 0.01 to 3 parts by mass relative to 100 parts by mass of the resin (A).

The resin stabilizer includes, for example, imidazole-type resin stabilizer, dithiocarbamic acid salt-type resin stabilizer, phosphorus-containing resin stabilizer, sulfur ester-type resin stabilizer, etc.

The content of the resin stabilizer is preferably from 0.01 to 3 parts by mass relative to 100 parts by mass of the resin (A).

An organic solvent, such as toluene, ethyl acetate, methyl ethyl ketone or the like, may be added to the adhesive composition (I) of the present invention to give a solution of the adhesive composition.

The solid concentration of the solution of the adhesive composition, as prepared by adding an organic solvent to the composition, is preferably from 10 to 60% by mass, more preferably from 10 to 45% by mass, even more preferably from 15 to 30% by mass. When the concentration is at least 10% by mass, the amount of the organic solvent to be used is sufficient, and when at most 60% by mass, then the solution could have a suitable viscosity and could secure excellent coatability therewith.

### [First Invention: Adhesive Sheet (I)]

Not specifically defined, the adhesive sheet (I) of the first aspect of the present invention may be any one having an adhesive layer formed of the adhesive composition (I) of the present invention that contains the above-mentioned components.

Even though the adhesive layer therein is thin, the adhesive sheet (I) of the present invention could still have high adhesion force, and the adhesive sheet (I) can express relatively high adhesion force irrespective of the type of the adherend to which it is applied.

Concretely, when the adherend is a stainless plate, the adhesion force of the adhesive sheet (I) in which the adhesive layer has a thickness of 20 µm is preferably at least 10 N/25 mm, more preferably at least 12 N/25 mm, even more preferably at least 15 N/25 mm.

In case where the adherend is an aluminium-deposited surface, the adhesion force of the adhesive sheet (I) in which the adhesive layer has a thickness of 20 µm is preferably at least 3 N/25 mm, more preferably at least 5 N/25 mm, even more preferably at least 10 N/25 mm.

In case where the adherend is polyethylene terephthalate, the adhesion force of the adhesive sheet (I) in which the adhesive layer has a thickness of 20 µm is preferably at least 3 N/25 mm, more preferably at least 5 N/25 mm, even more preferably at least 10 N/25 mm.

In case where the adherend is glass, the adhesion force of the adhesive sheet (I) in which the adhesive layer has a thickness of 20 µm is preferably at least 3 N/25 mm, more preferably at least 5 N/25 mm, even more preferably at least 10 N/25 mm.

In case where the adherend is an ITO-deposited surface, the adhesion force of the adhesive sheet (I) in which the adhesive layer has a thickness of 20 µm is preferably at least 2 N/25 mm, more preferably at least 3 N/25 mm, even more preferably at least 5 N/25 mm.

In case where the adhesive sheet of the present invention is a substrateless one, preferably, the adhesion force thereof lined with 25 µm-thick polyethylene terephthalate is preferably so controlled as to fall within the above-mentioned range.

The adhesive sheet (I) of the present invention has not only high adhesion force but also excellent retention force. The retention force of the adhesive sheet (I) of the present invention is, as measured according to the evaluation method described in the section of Examples, preferably such that, when a stainless plate is used as the adherend and when a weight of 1 kg is attached thereto at 40°C, the sheet could not completely slip off even after 70000 seconds, and even when the sheet has slipped off, the length of the movement of the sheet is preferably not more than 5.0 mm, more preferably not more than 3.5 mm.

The moisture vapor transmission rate at 40°C and at 90% RH (relative humidity) of the adhesive layer having a thickness of 50 µm of the adhesive sheet (I) of the present invention is preferably at most 10 g/m²/day, more preferably at most 7 g/m²/day, even more preferably at most 5 g/m²/day, still more preferably at most 4 g/m²/day. When the moisture vapor transmission rate of the adhesive layer is at most 10 g/m²/day, the adhesive layer can fully prevent moisture vapor penetration therethrough even when the sheet is used for sealing up organic EL elements, etc.

The adhesive sheet (I) of the present invention has excellent transparency.

Preferably, the visible light transmittance at a wavelength of 550 nm of the adhesive layer having a thickness of 50 µm of the adhesive sheet (I) of the present invention is at least 90%. When the visible light transmittance of the adhesive layer is at least 90%, then the sheet can be favorably used for sealing up organic EL elements, etc.

Further, the adhesive sheet (I) of the present invention can be fully prevented from being discolored (yellowed).

When the light transmittance at a wavelength of from 1000 to 300 nm of the adhesive layer having a thickness of 50 µm of the adhesive sheet (I) is measured after the sheet has been left in a dry environment at 80°C for 8 weeks, the degree of yellowness of the sheet is preferably at most 2.0, more preferably at most 1.0, even more preferably at most 0.5. When the yellowness is at most 2.0, then the light transmittance of the adhesive sheet is excellent and, in addition, the sheet discolors little and is therefore further favorable for use in sealing up organic EL elements, etc.

The adhesive sheet (I) of the present invention can lower the amount of outgas generation from the sheet. In the present invention, the outgas generation amount may be evaluated by comparison of the n-decane-equivalent amount from the sheet.

When the adhesive sheet (I) in which the adhesive layer has a thickness of 50 µm is heated at a temperature of 120°C for 30 minutes, the n-decane-equivalent amount of outgas generation from the sheet is preferably less than 1.0 µg/cm², and more preferably not more than 0.5 µg/cm². When the amount is less than 1.0 µg/cm², then the adhesive layer does not corrode adherends and, for example, even in a case where the sheet is applied for bonding to precision instruments, the possibility that the sheet would cause false operation of the precision electronic parts can be remarkably reduced.

The data of the adhesion force, the retention force, the moisture vapor transmission rate, the visible light transmittance and the outgas generation amount of the adhesive sheet (I) are those measured according to the methods described in the section of Examples.

The concrete configuration of the adhesive sheet (I) and the production method for the sheet are the same as those of the adhesive sheet (II), and are therefore collectively described hereinunder.

### [Second Invention: Adhesive Sheet]

The second aspect of the present invention relates to an adhesive sheet (II) having at least one adhesive layer, wherein the probe tack of the adhesive layer, as measured at a peel rate of 600 mm/min according to JIS-Z0237 (1991), has two maximum values and wherein the first maximum value P1 detected first is at least 4.0 N and the ratio of the second maximum value P2 detected secondarily to the first maximum value P1 [P2/P1] is from 0.25 to 1.50.

The probe tack of the adhesive layer is measured at a peel rate of 600 mm/min according to JIS-Z0237 (1991), and concretely measured using a probe tack tester according to the method described in the section of Examples.

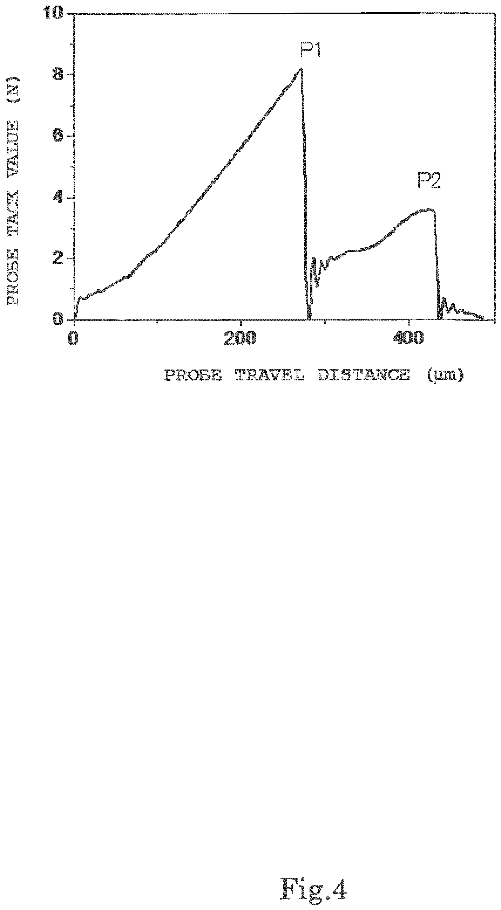

In the present invention, the probe tack, as measured according to the above-mentioned method, of the adhesive layer that the adhesive sheet (II) possesses has two maximum values. For example, Fig. 4 is a chart of the probe tack, as measured according to the above-mentioned method, of the adhesive sheet produced in Example 1 to be given hereinunder. In Fig. 4, there are detected two maximum values, P1 and P2 in that order with the increase in the movement of the probe.

In the present invention, when the movement of the probe is gradually increased from 0, the maximum value detected first is referred to as P1 and the maximum value detected secondarily is referred to as P2.

In case where the adhesive sheet of the present invention is a substrateless one, the sheet is measured while it is lined with a 25 µm-thick polyethylene terephthalate and while the side opposite to the measuring surface thereof is fixed.

Of the two maximum values of the probe tack of the adhesive layer that the adhesive sheet (II) of the present invention possesses, the first maximum value P1 detected first is at least 4.0 N. When the first maximum value P1 is less than 4.0, then it is unfavorable since the adhesion force of the sheet would be poor to some adherends.

From the viewpoint of securing excellent adhesion force irrespective of the type of adherends, the first maximum value P1 is preferably from 4.2 to 9.0 N, more preferably from 4.4 to 8.0 N, even more preferably from 4.7 to 6.5 N.

Of the two maximum values of the probe tack of the adhesive layer that the adhesive sheet (II) of the present invention possesses, the ratio of the second maximum value P2 detected secondarily to the first maximum value [P2/P1] is from 0.25 to 1.50. When the ratio is less than 0.25, then it is unfavorable since the adhesion force of the sheet to adherends such as glass or the like is poor. On the other hand, when the ratio is more than 1.50, it is also unfavorable since the adhesive agent is hard and therefore cannot secure initial wettability for adherends.

From the viewpoint of securing excellent adhesion force and of preventing occurrence of zipping irrespective of the type of adherends, the ratio of the second maximum value P2 to the first maximum value [P2/P1] is preferably from 0.30 to 1.00, more preferably from 0.35 to 0.90, even more preferably from 0.40 to 0.85, still more preferably from 0.40 to 0.75.

The second maximum value P2 is not specifically defined so far as the above-mentioned ratio P2/P1 satisfies the above-mentioned requirement, but is preferably from 1.6 to 8.0 N, more preferably from 2. 0 to 7. 0 N, even more preferably from 2.4 N to 6.0 N.

The adhesive composition to be the material to form the adhesive layer that the adhesive sheet (II) of the second invention possesses is not specifically defined so far as the composition can form the adhesive layer having, as measured according to the above-mentioned predetermined method, a probe tack with two maximum values that satisfy the above-mentioned requirements.

The adhesive composition to be the adhesive layer satisfying the above-mentioned requirements is an adhesive composition that comprises a polyisobutylene-based resin (A') having a weight-average molecular weight of from 270,000 to 480,000 (hereinafter this may be referred to as "polyisobutylene-based resin (A') or "resin (A')"), a polyisobutylene-based resin (B') having a weight-average molecular weight of from 100,000 to 250,000 (hereinafter this may be referred to as "polyisobutylene-based resin (B') or "resin (B')"), and a hydrogenated petroleum resin (C') having a softening point of from 90 to 135°C (hereinafter this may be referred to as "hydrogenated petroleum resin (C')"), and hereinunder the adhesive composition of the type may be referred to as "adhesive composition (II)".

The components (A') to (C') and other additives to be contained in the adhesive composition (II) are described in detail hereinunder.

### <Polyisobutylene-based Resin (A')>

The adhesive composition (II) contains the polyisobutylene-based resin (A') having a weight-average molecular weight of from 270,000 to 480,000. Containing the polyisobutylene-based resin (A') having a specific weight-average molecular weight, the durability and the weather resistance of the adhesive sheet can be improved and the moisture vapor transmission rate thereof can be lowered.

Regarding the structure thereof, the polyisobutylene-based resin (A') has a polyisobutylene skeleton in the main chain or in the side chain thereof, and has the above-mentioned structural unit (a).

The resin (A') includes the same as those of the above-mentioned resin (A). One alone or two or more of such resins (A') may be used here either singly or as combined. When the resin (A') is a copolymer, a structural unit of isobutylene shall be most of all the monomer components therein.

Of the resins (A'), from the viewpoint of securing high durability and high weather resistance and of lowering the moisture vapor transmission rate of the adhesive sheet, preferred are ones having a dense molecular structure when polymerized and having a large content a structural unit of isobutylene that could not leave a polymerizing double bond in the main chain and in the side chain.

The content of the structural unit of isobutylene in the resin (A) is preferably from 80 to 100% by mass of all the structural units contained therein, more preferably from 90 to 100% by mass, even more preferably 100% by mass.

Regarding the method of producing the resin (A'), there is mentioned the same method as that mentioned hereinabove for production of the resin (A).

The weight-average molecular weight of the resin (A') is, from the viewpoint of improving the cohesion force of the adhesive composition and lowering the moisture vapor transmission rate thereof, preferably from 270, 000 to 480,000, more preferably from 300,000 to 450,000, even more preferably from 320,000 to 400,000, still more preferably from 340,000 to 370,000.

When the weight-average molecular weight is at least 270,000, then the cohesive force of the adhesive composition would be sufficient and the moisture vapor transmission rate thereof could be thereby lowered. If so, in addition, adherends could be prevented from being contaminated. Basically, the resin having a higher weight-average molecular weight could lower the moisture vapor transmission rate thereof and could improve the retention force thereof.

On the other hand, when at most 480,000, the resin could evade the disadvantages that the cohesion force of the adhesive composition would be too high and therefore the flexibility and the flowability thereof would be thereby worsened and the composition could not well wet adherends. If so, in addition, the solubility of the adhesive composition in solvent could be prevented from being lowered in preparing the composition.

### <Polyisobutylene-based Resin (B')>

The adhesive composition (II) contains the polyisobutylene-based resin (B') having a weight-average molecular weight of from 100,000 to 250,000. Containing the polyisobutylene-based resin (B') having a specific weight-average molecular weight, the composition can provide excellent adhesion force irrespective of the type of the adherent to which it is applied, and the balance of the adhesion force and the retention force of the composition can be thereby improved. In addition, the above-mentioned first maximum value P1 can be controlled to be not smaller than a predetermined value.

Regarding the structure thereof, the polyisobutylene-based resin (B') has, like the resin (A'), a polyisobutylene skeleton in the main chain or in the side chain thereof and has the above-mentioned structural unit (a).

As examples of the resin (B'), those exemplified for the above-mentioned resin (A') can be mentioned, but from the viewpoint of securing high durability and high weather resistance and of lowering the moisture vapor transmission rate thereof, preferred are ones having a dense molecular structure when polymerized and having a large content of a structural unit of isobutylene that could not leave a polymerizing double bond in the main chain and in the side chain.

The content of the structural unit of isobutylene in the resin (B') is preferably from 80 to 100% by mass of all the structural units contained therein, more preferably from 90 to 100% by mass, even more preferably 100% by mass.

One alone or two or more different types of the resin (B') can be used here either singly or as combined. The method for producing the resin (B') and the commercial products usable for the resin are the same as those described hereinabove in the section of the resin (A').

The resin (B') is well miscible with the resin (A') and suitably plasticizes the resin (A'), thereby enhancing the wettability of the composition for adherends and improving the adhesiveness, the flexibility and the retention force thereof.

The weight-average molecular weight of the resin (B') is, from the viewpoint of securing good miscibility with the resin (A') to plasticize the resin (A') and of retarding the influence of the resin on the other physical properties such as the moisture vapor transmission rate and others of the composition, preferably from 100,000 to 250,000, more preferably from 120, 000 to 230, 000, even more preferably from 150, 000 to 220, 000, still more preferably from 180,000 to 210,000.

When the weight-average molecular weight is at least 100,000, then the resin (B') could evade the disadvantages of having some negative influences on the physical properties of the composition in that the resin would be separated as a low-molecular component to contaminate adherends, or the amount of outgas to be generated at high temperatures would increase. On the other hand, when at most 250,000, the resin could fully plasticize the resin (A') and could secure good wettability for adherends thereby improving the adhesion force of the composition.

The content of the polyisobutylene resin (B') in the adhesive composition (II) is, from the viewpoint of the balance between the adhesion force and the retention force and the effect of reducing the moisture vapor transmission rate, preferably from 5 to 55 parts by mass relative to 100 parts by mass of the resin (A'), more preferably from 7 to 40 parts by mass, even more preferably from 8 to 30 parts by mass, still more preferably from 9 to 20 parts by mass.

When the content is at least 5 parts by mass, the resin (A') could be fully plasticized and good wettability for adherends could be thereby provided, and therefore the adhesion force of the composition would better. On the other hand, when at most 55 parts by mass, the cohesion force could be prevented from being lowered and therefore excellent adhesion force and retention force could be thereby provided and the resistance to sunlight and UV ray could also be bettered.

### <Hydrogenated Petroleum Resin (C')>

The hydrogenated petroleum resin (C') to be contained in the adhesive composition (II) means a product produced by hydrogenating petroleum resin, and includes not only a completely hydrogenated resin but also a partially hydrogenated resin having a different degree of hydrogenation. The "petroleum resin" is as described above.

The composition contains the hydrogenated petroleum resin (C') having a softening point of from 90 to 135°C, by which the resin (A') and the resin (B') therein can be prevented from being discolored (yellowed) by high wet heat or UV ray. In addition, the ratio of the second maximum value P2 to the first maximum value P1 [P2/P1] can be controlled to fall within a predetermined range.

The hydrogenated petroleum resin to be used here is, from the viewpoint of the miscibility thereof with the resin (A') and the resin (B'), the effect thereof to lower the moisture vapor transmission rate of the composition and the resistance of the composition to high wet heat and UV ray, preferably a completely hydrogenated petroleum resin.

Concretely, the hydrogenated petroleum resin is preferably at least one or more selected from a group consisting of a hydrogenated resin of a C5 petroleum resin obtained through copolymerization of a C5 fraction, a hydrogenated resin of a C9 petroleum resin obtained through copolymerization of a C9 fraction, and a hydrogenated resin of a copolymerized petroleum resin of a C5 fraction and a C9 fraction, and from the viewpoint of low moisture vapor permeability and good transparency, more preferred is a hydrogenated resin of a copolymerized petroleum resin of a C5 fraction and a C9 fraction.

The "C5 fraction", "C5 petroleum resin" , "C9 fraction and "C9 petroleum resin" are as described above.

One alone or two or more different types of the hydrogenated petroleum resin (C') may be used here either singly or as combined.

The softening point of the hydrogenated petroleum resin (C') is, from the viewpoint of giving excellent adhesion force to the adhesive sheet irrespective of the type of the adherend to which the sheet is applied and from the viewpoint of improving the balance between the adhesion force and the retention force of the sheet, and also from the viewpoint of controlling the ratio of the second maximum value P2 to the first maximum value P1 [P2/P1] to fall within the predetermined range, preferably from 90 to 135°C, more preferably from 95 to 130°C, even more preferably from 98 to 128°C, still more preferably from 105 to 120°C. When the softening point is not lower than 90°C, then the adhesive composition could have sufficient cohesion force and could have sufficient adhesion force. On the other hand, when the softening point is not higher than 135°C, then the composition could secure sufficient adhesion force to adherends such as glass or the like and, in addition, could prevent zipping that may occur in peeling the adhesive sheet.

As the case may be, two or more different hydrogenated petroleum resins (C') each having a different softening point may be combined here to thereby enhance the adhesion force of the composition.

The content of the hydrogenated petroleum resin (C') in the adhesive composition (II) is, from the viewpoint of improving the adhesion force and the retention force irrespective of the type of adherends, preferably from 10 to 55 parts by mass relative to 100 parts by mass of the resin (A'), more preferably from 12 to 50 parts by mass, even more preferably from 14 to 45 parts by mass, still more preferably from 16 to 35 parts by mass, further more preferably from 18 to 25 parts by mass. When the content is at least 10 parts by mass, then the power of the resin to give adhesiveness to the composition would be good and the composition could secure sufficient wettability for adherends and could secure sufficient adhesion force. On the other hand, when the content is at most 55 parts by mass, then the adhesive composition could secure sufficient cohesion force and could have excellent retention force so that, when bonded to an adherend, the composition would hardly peel away. If so, in addition, the composition could secure sufficient adhesion force especially to adherends such as glass, ITO, etc.

### <Other Additives>

Within a range not detracting from the adhesiveness thereof, the adhesive composition (II) may contain light stabilizer, antioxidant, UV absorbent, resin stabilizer, filler, pigment, extender, etc. One alone or two or more such additives may be used here either singly or as combined. Specific examples of these additives in the adhesive composition (II) and preferred contents thereof are the same as those in the adhesive composition (I).

An organic solvent, such as toluene, ethyl acetate, methyl ethyl ketone or the like, may be added to the adhesive composition (II).

The solid concentration of the solution of the adhesive composition (II), as prepared by adding an organic solvent thereto, is preferably from 10 to 60% by mass, more preferably from 10 to 45% by mass, even more preferably from 15 to 30% by mass, from the same viewpoint as that for the adhesive composition (I) mentioned hereinabove.

### [Properties of Adhesive Sheet (II)]

Even though the adhesive layer therein is thin, the adhesive sheet (II) of the present invention could still have high adhesion force, and the adhesive sheet (II) can express relatively high adhesion force irrespective of the type of the adherend to which it is applied.

Concretely, when the adherend is a stainless plate, the adhesion force of the adhesive sheet (II) in which the adhesive layer has a thickness of 20 µm is preferably at least 10 N/25 mm, more preferably at least 12 N/25 mm, even more preferably at least 15 N/25 mm.

In case where the adherend is an aluminium-deposited surface, the adhesion force of the adhesive sheet (II) in which the adhesive layer has a thickness of 20 µm is preferably at least 10 N/25 mm, more preferably at least 12 N/25 mm, even more preferably at least 15 N/25 mm.

In case where the adherend is polyethylene terephthalate, the adhesion force of the adhesive sheet (II) in which the adhesive layer has a thickness of 20 µm is preferably at least 7 N/25 mm, more preferably at least 10 N/25 mm, even more preferably at least 15 N/25 mm.

In case where the adherend is glass, the adhesion force of the adhesive sheet (II) in which the adhesive layer has a thickness of 20 µm is preferably at least 8 N/25 mm, more preferably at least 10 N/25 mm, even more preferably at least 12 N/25 mm.

In case where the adherend is an ITO-deposited surface, the adhesion force of the adhesive sheet (II) in which the adhesive layer has a thickness of 20 µm is preferably at least 2 N/25 mm, more preferably at least 4 N/25 mm, even more preferably at least 6 N/25 mm.

The adhesive sheet (II) of the present invention has not only high adhesion force but also excellent retention force. The retention force of the adhesive sheet (II) of the present invention is, as measured according to the evaluation method described in the section of Examples, preferably such that, when a stainless plate is used as the adherend and when a weight of 1 kg is attached thereto at 40°C, the sheet could not completely slip off even after 70000 seconds, and even when the sheet has slipped off, the length of the movement of the sheet is preferably not more than 5.0 mm, more preferably not more than 3.5 mm.

The moisture vapor transmission rate at 40°C and at 90% RH (relative humidity) of the adhesive layer having a thickness of 50 µm of the adhesive sheet (II) of the present invention is preferably at most 10 g/m²/day, more preferably at most 7 g/m²/day, even more preferably at most 5.5 g/m²/day. When the moisture vapor transmission rate of the adhesive layer is at most 10 g/m²/day, the adhesive layer can fully prevent moisture vapor penetration therethrough even when the sheet is used for sealing up organic EL elements, etc.

The adhesive sheet (II) of the present invention has excellent transparency.

Preferably, the visible light transmittance at a wavelength of 550 nm of the adhesive layer having a thickness of 50 µm of the adhesive sheet (II) of the present invention is at least 90%. When the visible light transmittance of the adhesive layer is at least 90%, then the sheet can be favorably used for sealing up organic EL elements, etc.

Further, the adhesive sheet (II) of the present invention can be fully prevented from being discolored (yellowed).

When the light transmittance at a wavelength of from 1000 to 300 nm of the adhesive layer having a thickness of 50 µm of the adhesive sheet (II) is measured after the sheet has been left in a dry environment at 80°C for 8 weeks, the degree of yellowness of the sheet is preferably at most 2.0, more preferably at most 1.0, even more preferably at most 0.5, still more preferably at most 0.2. When the yellowness is at most 2.0, then the light transmittance of the adhesive sheet is excellent and, in addition, the sheet discolors little and is therefore further favorable for use in sealing up organic EL elements, etc.

The adhesive sheet (II) of the present invention can lower the amount of outgas generation from the sheet. In the present invention, the outgas generation amount may be evaluated by comparison of the n-decane-equivalent amount from the sheet. When the adhesive sheet (II) in which the adhesive layer has a thickness of 50 µm is heated at a temperature of 120°C for 30 minutes, the n-decane-equivalent amount of outgas generation from the sheet is preferably less than 1.0 µg/cm², and more preferably not more than 0.5 µg/cm². When the amount is less than 1.0 µg/cm², then the adhesive layer does not corrode adherends and, for example, even in a case where the sheet is applied for bonding to precision instruments, the possibility that the sheet would cause false operation of the precision electronic parts can be remarkably reduced.

The data of the adhesion force, the retention force, the moisture vapor transmission rate, the visible light transmittance and the outgas generation amount of the adhesive sheet (II) are those measured according to the methods described in the section of Examples.

The configuration of the adhesive sheet (II) of the present invention and the production method for the sheet are the same as those of the adhesive sheet (I), and are as described below.

### [Configuration of Adhesive Sheets (I) and (II) of the Invention]

Concrete configurations of the adhesive sheet (I) of the first aspect of the present invention and the adhesive sheet (II) of the second aspect of the present invention (hereinafter these may be collectively referred to as "adhesive sheet of the present invention") are described below.

The adhesive sheet (I) is not specifically defined so far as the sheet has an adhesive layer formed of the adhesive composition of the above-mentioned first invention.

The adhesive sheet (II) is not also specifically defined so far as the sheet has at least one adhesive layer and the probe tack of the adhesive layer, as measured according to the above-mentioned method, has two maximum values satisfying the above-mentioned specific requirements.

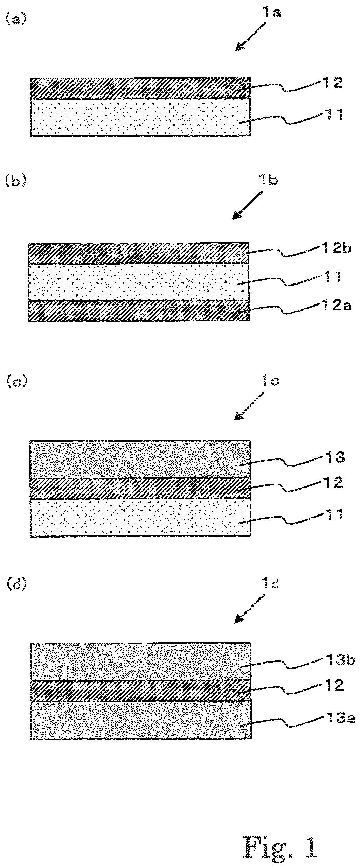

Regarding the configuration of the adhesive sheet of the present invention, for example, there may be mentioned the adhesive sheet 1a having an adhesive layer 12 formed on the substrate 11, as in Fig. 1(a), or that is, the configuration of the adhesive sheet is not specifically defined so far as the sheet has at least one adhesive layer.

There may be further mentioned the adhesive sheet 1b having adhesive layers 12a and 12b formed on both sides of the substrate 11, for example, as in Fig. 1(b); and the adhesive sheet 1c having a separable release material 13 further formed on the adhesive layer 12 formed on the substrate 11, as in Fig 1(c). The adhesive sheet 1b may additionally have a release material on the adhesive layers 12a and 12b.

Further, as in Fig. 1(d), there may be mentioned the adhesive sheet 1d in which the adhesive layer 12 is sandwiched between two release materials (release materials 13a, 13b) not using a substrate. In the adhesive sheet 1d, the release materials 13a and 13b may be the same or different. Preferably, the release materials to be used are suitably so selected that the release material 13a and the release material 13b differ in point of the peel force thereof.

Apart from the above, the adhesive sheet may be so configured that the adhesive layer is provided on one side of a release material of which the surface has been processed for lubrication, and the sheet is wound up into a roll.

Not specifically defined, the shape of the adhesive sheet of the present invention includes, for example, a sheet-like form, a roll-like form, etc. For example, for use as a part of electronic devices, the shape of the adhesive sheet is preferably a sheet-like form.

### <Substrate>

Not specifically defined, the substrate may be any sheet-like one, and can be suitably selected in accordance with the intended use of the adhesive sheet of the present invention. For example, the substrate includes paper substrates, such as high-quality paper, art paper, coated paper, glassine paper, etc.; other various paper substrates such as laminated paper substrates and the like produced by laminating a thermoplastic resin such as polyethylene or the like on the above-mentioned paper substrates; various synthetic paper substrates; metal foils such as aluminium foil, copper foil, iron foil, etc.; porous material substrates such as nonwoven fabric, etc.; plastic films or plastic sheets of resins such as polyolefin resins, e.g., polyethylene resin, polypropylene resin, etc., polyester resins, e.g., polybutylene terephthalate resin, polyethylene terephthalate resin, etc., acetate resins, ABS resins, polystyrene resins, vinyl chloride resins, etc., and their mixtures or laminates, etc. The substrates of plastic films or plastic sheets may be unstretched, or may be stretched monoaxially or biaxially, for example, in the machine direction or in the lateral direction.

The substrate to be used here is not specifically defined in point of the presence or absence of coloration thereof, but for use for sealants, preferred is a substrate that can sufficiently transmit UV rays, and more preferred is a substrate that is colorless and transparent even in a visible light region.

In the adhesive sheet of the present invention, a gas barrier film having a gas barrier layer may be used as the substrate in place of the substrate formed of the above-mentioned material. The details of the gas barrier film are described below.

The thickness of the substrate is not specifically defined; however, from the viewpoint of the handleability thereof, the thickness is preferably from 10 to 250 µm, more preferably from 15 to 200 µm, even more preferably from 20 to 150 µm.

The substrate may contain a UV absorbent, a light stabilizer, an antioxidant, an antistatic agent, a slip agent, an antiblocking agent, a colorant, etc.

In case where the substrate is formed of a plastic material, it is desirable to optionally process the surface of the substrate for surface treatment according to an oxidation method, a roughening method or the like for the purpose of improving the adhesiveness between the substrate and the adhesive layer.

Not specifically defined, the oxidation method includes, for example, a corona discharge treatment method, a plasma treatment method, chromic acid oxidation (wet treatment), flame treatment, hot air treatment, ozone/UV irradiation treatment, etc. Also not specifically defined, the roughening method includes, for example, a sandblasting method, a solvent treatment method, etc.

These surface treatments may be suitably selected depending on the type of the substrate, but preferred is a corona discharge treatment method from the viewpoint of the effect to improve the adhesiveness to the adhesive layer and of the operability. Primer treatment may be given to the substrate.

Also if desired, a filling-up layer may be provided between the substrate and the adhesive layer, depending on the type of the substrate. The filling-up layer may be provided for further improving the adhesiveness between the substrate and the adhesive layer, in addition to the purpose for preventing the adhesive composition or a solution of the adhesive composition from penetrating into the substrate, or in case where the substrate is paper and is too labile, the filling-up layer may be provided for stiffening the substrate.

Not specifically defined, the filling-up layer may be a layer of a resin composition comprising, for example, a styrene-butadiene copolymer, an acrylic resin, a polyester resin, a polyurethane resin, a polystyrene resin or the like as the main component (that is, containing the resin component in an amount of at least 20% by mass), and optionally containing a filler such as clay, silica, calcium carbonate, titanium oxide, zinc oxide or the like added thereto.

Not specifically defined, the thickness of the filling-up layer is generally within a range of from 0.1 to 30 µm.

### <Gas Barrier Film>

In the adhesive sheet of the present invention, a gas barrier film having a gas barrier layer may be used as the substrate in place of the substrate formed of the above-mentioned material. The gas barrier film may have a gas barrier layer on at least one surface of a gas barrier film substrate.

### (Gas Barrier Film Substrate)

Not specifically defined, the gas barrier film substrate includes sheets and the like of a polyolefin such as polyethylene, polypropylene, etc.; a polyester such as polyethylene terephthalate, polybutylene terephthalate, etc. ; a polyamide such as polyimide, polyamideimide, a whole aromatic polyamide, nylon 6, nylon 66, nylon copolymer, etc. ; norbornene copolymers, monocyclic olefinic polymers, cyclic conjugated diene polymers, vinyl-alicyclic hydrocarbon polymers, and their hydrogenated products, cycloolefin-based polymers, etc.; other resins such as polyphenylene ether, polyether ketone, polyether ether ketone, polycarbonate, polysulfone, polyether sulfone, polyphenylene sulfide, polyacrylate, etc.

Of those, preferred are polyesters, polyamides or cycloolefin-based polymers, from the viewpoint of excellent transparency and general versatility thereof; and more preferred are polyesters or cycloolefin-based polymers.

Not specifically defined, the thickness of the gas barrier film substrate is preferably from 2 to 200 µm, more preferably from 10 to 150 µm, even more preferably from 20 to 100 µm from the viewpoint of the handleability thereof.

### (Gas Barrier Layer)

Not specifically defined, the material to form the gas barrier layer may be any one capable of preventing penetration of oxygen and moisture vapor therethrough, and includes, for example, metals such as aluminium, magnesium, zinc, tin, etc.; silicon compounds such as silicon nitride, silicon oxide, silicon oxynitride, polysilazane compound, polycarbosilane compound, polysilane compound, polyorganosiloxane compound, tetraorganosilane compound, etc.; aluminium compounds such as aluminium oxide, aluminium oxynitride, etc.; inorganic oxides such as magnesium oxide, zinc oxide, indium oxide, tin oxide, etc. ; resins such as polyvinyl alcohol, ethylene-vinyl alcohol copolymer, polyvinyl chloride, polyvinylidene chloride, polychlorotrifluoroethylene, etc.

Of those, preferred are metals such as aluminium, magnesium, zinc, tin, etc., silicon compounds such as silicon nitride, silicon oxide, silicon oxynitride, polysilazane compound, polycarbosilane compound, polysilane compound, polyorganosiloxane compound, tetraorganosilane compound, etc., aluminium compounds such as aluminium oxide, aluminium oxynitride, etc., inorganic oxides such as magnesium oxide, zinc oxide, indium oxide, tin oxide, etc., from the viewpoint of improving the gas barrier property of the layer; and from the viewpoint of the transparency of the layer, more preferred are (1) polysilazane compound, (2) polycarbosilane compound, (3) polysilane compound, (4) polyorganosiloxane compound, and (5) tetraorganosilane compound.

The details of the above-mentioned compounds (1) to (5) are described below.

### ((1) Polysilazane Compound)

Polysilazane compound is a polymer having, in the molecule thereof, a recurring unit that contains a bond (-Si-N-), and includes a compound having a recurring unit represented by the following formula (1).

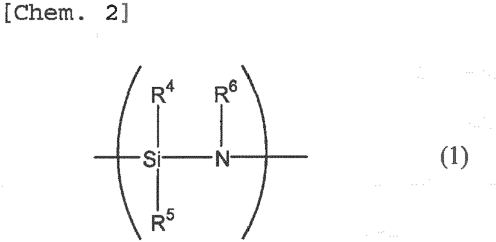

In the formula (1), R⁴, R⁵ and R⁶ each independently represent a hydrogen atom, or a non-hydrolysable group such as an unsubstituted or substituted alkyl group, an unsubstituted or substituted cycloalkyl group, an unsubstituted or substituted alkenyl group, an unsubstituted or substituted aryl group or alkylsilyl group, etc.

Of those, more preferred as R⁴ to R⁶ is a hydrogen atom, an alkyl group having from 1 to 6 carbon atoms, or a phenyl group; and even more preferred is a hydrogen atom.

As the polysilazane compound having the recurring unit represented by the formula (1), preferred from the viewpoint of the availability and of the ability thereof to form a layer having excellent gas barrier property, are inorganic polysilazanes in which R⁴ to R⁶ are all hydrogen atoms, or organic polysilazanes in which at least one of R⁴ to R⁶ is not a hydrogen atom; more preferred are inorganic polysilazanes; and even more preferred are perhydropolysilazanes.

Not specifically defined, the number-average molecular weight of the polysilazane compound is preferably from 100 to 50,000.

### ((2) Polycarbosilane Compound)

Polycarbosilane compound is a polymer compound having, in the main chain of the molecule, a recurring unit that contains a bond (-Si-C-), and includes a compound having a recurring unit represented by the following formula (2).

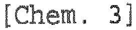

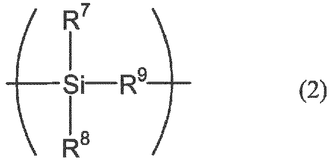

In the formula (2), R⁷ and R⁸ each independently represent a hydrogen atom, a hydroxyl group, an alkyl group, an aryl group, an aralkyl group, an alkenyl group, or a monovalent heterocyclic group. R⁷ and R⁸ may be the same or different. R⁹ represents an alkylene group, an arylene group or a divalent heterocyclic group.

As the polycarbosilane compound having a recurring unit represented by the formula (2), preferred are those in which R⁷ and R⁸ each independently represent a hydrogen atom, an alkyl group or an aryl group, and R⁹ represents an alkylene group or an arylene group; more preferred are those in which R⁷ and R⁸ each independently represent a hydrogen atom or an alkyl group, and R⁹ represents an alkylene group; and even more preferred are those in which R⁷ and R⁸ each independently represent a hydrogen atom or an alkyl group having from 1 to 4 carbon atoms, and R⁹ represents an alkylene group having from 1 to 6 carbon atoms.

The weight-average molecular weight of the polycarbosilane compound is generally from 400 to 12000.

### ((3) Polysilane Compound)

Polysilane compound is a polymer compound having, in the molecule, a recurring unit that contains a bond (-Si-Si-). The polysilane compound of the type includes compounds having a recurring unit represented by the following formula (3).

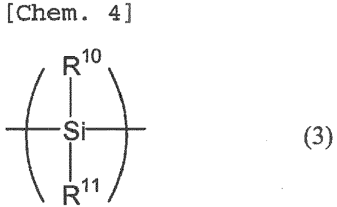

In the formula (3), R¹⁰ and R¹¹ each independently represent a hydrogen atom, a hydroxyl group, an alkyl group, a cycloalkyl group, an alkenyl group, a cycloalkenyl group, an aryl group, an alkoxy group, a cycloalkyloxy group, an aryloxy group, an aralkyloxy group, an amino group optionally having a substituent, a silyl group, or a halogen atom.

As the polysilane compound having the recurring unit represented by the formula (3), preferred are those in which R¹⁰ and R¹¹ each independently represent a hydrogen atom, an alkyl group, an aryl group, a hydroxyl group, an alkoxy group, an amino group or a silyl group; more preferred are those in which R¹⁰ and R¹¹ each independently represent a hydrogen atom, an alkyl group or an aryl group; and even more preferred are those in which R¹⁰ and R¹¹ each independently represent an alkyl group having from 1 to 4 carbon atoms or an aryl group.

The morphology of the polysilane compound is not specifically defined, and the compound may be a homopolymer, for example, an acyclic polysilane such as a linear polysilane, a branched polysilane, a network polysilane, etc.; or a cyclic polysilane, etc.; and may also be a copolymer such as a random copolymer, a block copolymer, an alternate copolymer, a comb-shaped copolymer, etc.

In case where the polysilane compound is an acyclic polysilane, the end group (end substituent) of the polysilane compound may be a hydrogen atom, or may also be a halogen atom such as a chlorine atom or the like, or an alkyl group, a hydroxyl group, an alkoxy group, a silyl group, etc.

Not specifically defined, the weight-average molecular weight of the polysilane compound is preferably from 300 to 100000, more preferably from 400 to 50000, even more preferably from 500 to 30000.

### ((4) Polyorganosiloxane Compound)

The main chain structure of polyorganosiloxane compound is not specifically defined, and the compound may have any of a linear, ladder or cage structure.

For example, the compound having a linear main chain structure includes a compound having a recurring unit represented by the following formula (4) ; the compound having a ladder-shaped main chain structure includes a compound having a recurring unit represented by the following formula (5); and the compound having a cage-shaped main chain structure includes a compound having a recurring unit represented by the following formula (6).

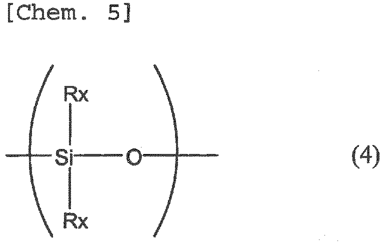

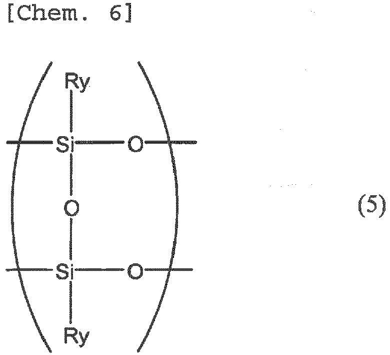

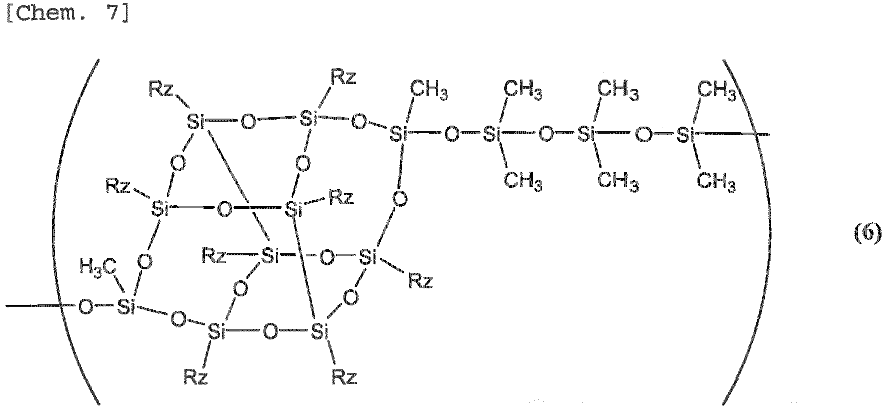

In the formulae (4) to (6), Rx, Ry and Rz each independently represent a hydrogen atom, or a non-hydrolysable group such as an unsubstituted or substituted alkyl group, an unsubstituted or substituted alkenyl group, an unsubstituted or substituted aryl group or the like. In the formulae, Rx, Ry and Rz each may be the same or different, but two Rx's in the formula (4) are not hydrogen atoms at the same time.

Of the above, preferred are those in which Rx, Ry and Rz each represent an unsubstituted or substituted, alkyl group with from 1 to 6 carbon atoms or phenyl group, and more preferably a methyl group, an ethyl group, a propyl group, a 3-glycidoxypropyl group or a phenyl group.

### ((5) Tetraorganosilane Compound)

Tetraorganosilane compound is a compound in which four hydrolysable groups bond to the silicon element, concretely including a compound represented by a formula (7): SiX₄.

In the formula (7): SiX₄, X's each represents hydrolysable substituent, and they may be the same or different.

X includes a group represented by a formula (8) : OR (where R represents a hydrocarbon group having from 1 to 10 carbon atoms, or an alkoxy group), a group represented by a formula (9): OSi (R^{a}) (R^{b}) (R^{c}) (where R^{a}, R^{b} and R^{c} each independently represent a hydrogen atom, an alkyl group having from 1 to 10 carbon atoms, or a phenyl group), a halogen atom such as a chlorine atom, a bromine atom, etc.

The tetraorganosilane compound includes, for example, tetra-(C1-C10)alkoxysilanes such as tetramethoxysilane, tetramethoxysilane, tetrapropoxysilane, tetraisopropoxysilane, tetrabutoxysilane, etc.; tri-(C1-C10)alkoxyhalogenosilanes such as trimethoxychlorosilane, triethoxychlorosilane, tripropoxychlorosilane, etc.; di-(C1-C10)dihalogenoalkoxysilanes such as dimethyldichlorosilane, diethoxydichlorosilane, dipropoxydichlorosilane, etc.; mono-(C1-C10)alkoxytrihalogenosilanes such as methoxytrichlorosilane, ethoxytrichlorosilane, propoxytrichlorosilane, etc.; tetrahalogenosilanes such as tetrachlorosilane, tetrabromosilane, etc. Here, "(C1-C10)" means that the carbon number is from 1 to 10.

One alone or two or more of these tetraorganosilane compounds may be used here either singly or as combined.

Of those, preferred are tetra- (C1-C10) alkoxysilanes from the viewpoint of excellent handleability and of the ability to enhance gas barrier property. Preferably, the tetraorganosilane compound is subjected to hydrolysis/dehydration-condensation in a suitable solvent and in the presence of water and optionally a catalyst.

Not specifically defined, the weight-average molecular weight of the hydrolyzed or dehydration-condensed, tetraorganosilane compound is, from the viewpoint of forming a gas barrier layer excellent in mechanical strength, preferably from 200 to 50000, more preferably from 200 to 30000, even more preferably from 200 to 10000. When the weight-average molecular weight is at least 200, then the compound has a sufficient film-forming capability; and when at most 50000, a film having a sufficient mechanical strength could be formed.

The method for forming the gas barrier layer is not specifically defined. For example, a solution prepared by dissolving the above-mentioned material in an organic solvent is applied onto a substrate and the coating film is suitably dried to form the layer thereon. The coating method is not specifically defined, for which is usable any coating method such as a spin coating method, a spray coating method, a bar coating method, a knife coating method, a roll coating method, a blade coating method, a die coating method, a gravure coating method, etc.

Any other forming method employable here includes a vapor deposition method, a sputtering method, an ion plating method, a thermal CVD method, a plasma CVD method or the like in which the above-mentioned material is applied onto a substrate to form thereon the intended layer.

The thickness of the gas barrier layer to be formed is, from the viewpoint of the gas barrier performance and the handleability thereof, preferably from 20 nm to 100 µm, more preferably from 30 to 500 nm, even more preferably from 40 to 200 nm. In the present invention, even when the gas barrier layer is a nano-order layer, the adhesive sheet can secure sufficient gas barrier performance.

Further, ion injection to the surface of the gas barrier layer is preferred. Ion injection improves the gas barrier performance of the layer kept having high transparency. The step of ion injection is not specifically defined. For example, employable here is a method of injecting ions into the gas barrier layer having been formed on a substrate.

The ion to be injected includes, for example, rare gas of argon, helium, neon, krypton, xenon, etc.; ions of fluorocarbon, hydrogen, nitrogen, oxygen, carbon dioxide, chlorine, fluorine, sulfur, etc.; metal ions of gold, silver, copper, platinum, nickel, palladium, chromium, titanium, molybdenum, niobium, tantalum, tungsten, aluminium, etc.

Of those, preferred is at least one type of ions selected from a group consisting of hydrogen, nitrogen, oxygen, argon, helium, neon, xenon and krypton, from the viewpoint that the ion injection is attainable in a more simplified manner and can provide an adhesive sheet having especially excellent gas barrier performance and transparency.

The ion injection dose may be suitably selected in consideration of the intended use of the adhesive sheet such as the necessary gas barrier level and transparency thereof.

For the ion injection, herein employable are a method of irradiating the layer with ions (ion beams) accelerated in an electric field, a method of injecting ions in plasma into the layer (plasma ion injection method), etc. Of those, preferred is the plasma ion injection method from the viewpoint of providing an adhesive sheet having an excellent gas barrier property in a simplified manner.

The plasma ion injection method comprises, for example, generating ion plasma in an atmosphere containing a plasma-forming gas and then applying a negative high-voltage pulse to a gas barrier layer to thereby inject the ion (cation) in the plasma into the surface part of the gas barrier layer.

The thickness of the part into which ions are injected may be controlled depending on the injection conditions such as the type of ion, the voltage to be applied, the processing time, etc., and may be determined in accordance with the thickness of the gas barrier layer, the intended use of the adhesive sheet, etc. In general, the thickness is from 10 to 1000 nm, preferably from 10 to 200 nm.

The moisture vapor transmission rate at 40°C and 90% RH (relative humidity) of the gas barrier layer having a thickness of 75 nm of the thus-obtained gas barrier film is preferably at most 0.5 g/m²/day, more preferably at most 0.05 g/m²/day.

The transmission rate of moisture vapor or the like through the gas barrier film can be measured, using a known gas transmission rate-measuring apparatus.

### <Release Material>

As the release material, usable here are a release sheet with both sides processed for lubrication treatment, a release sheet with one side processed for lubrication treatment, etc.; and there may be mentioned those produced by coating a substrate with a release agent, etc.

The substrate for release material includes, for example, paper substrates such as glassine paper, coated paper, high-quality paper, etc. ; laminated paper substrates produced by laminating a thermoplastic resin such as polyethylene or the like on these paper substrates; plastic films such as polyester resin films of polyethylene terephthalate resin, polybutylene terephthalate resin, polyethylene naphthalate resin or the like, polyolefin resin films of polypropylene resin, polyethylene resin or the like, etc.

The release agent includes, for example, rubber elastomers such as silicone resin, olefinic resin, isoprenic resin, butadienic resin, etc.; long-chain alkyl resins, alkyd resins, fluororesins, etc.

Not specifically defined, the thickness of the release material is generally from 20 to 200 µm but is preferably from 25 to 150 µm.

### [Production Method for Adhesive Sheets (I) and (II) of the Invention)

The production method for the adhesive sheets (I) and (II) of the present invention is not specifically defined, and the sheets can be produced according to any known method. For example, there is mentioned a method for producing the adhesive sheets, which comprises adding an organic solvent to the above-mentioned adhesive composition to prepare a solution of the adhesive composition, then applying the solution onto a substrate according to a known coating method.

The coating method may be any known coating method including, for example, a spin coating method, a spray coating method, a bar coating method, a knife coating method, a roll coating method, a blade coating method, a die coating method, a gravure coating method, etc.

Concrete production methods are mentioned below, depending on the configuration of the adhesive sheet to be produced.

The adhesive sheet 1a having an adhesive layer on one side of a substrate, as in Fig. 1(a), can be produced, for example, by directly applying a solution of the above-mentioned adhesive composition on one side of the substrate 11 to form thereon the adhesive layer 12. The adhesive sheet of the type may also be produced by removing the two release materials from the double-sided adhesive sheet 1d as in Fig. 1(d), followed by sticking the exposed adhesive layer to one surface of the substrate 11.

The adhesive sheet 1b having an adhesive layer on both sides of a substrate, as in Fig. 1(b), can be produced, for example, by directly applying a solution of the adhesive composition on both sides of the substrate 11 to form the adhesive layers 12a and 12b thereon. The adhesive sheet of the type may also be produced by removing one release material from the double-sided adhesive sheet 1d as in Fig. 1(d), followed by sticking the exposed adhesive layer to one surface of the substrate 11 and further directly applying a solution of the adhesive composition onto the other side of the substrate 11.

The adhesive sheet 1c having an adhesive layer and a release material in that order on a substrate, as in Fig. 1(c), can be produced, for example, by laminating the release material 13 onto the adhesive side of the adhesive sheet 1a produced as in the above. The adhesive sheet of the type may also be produced by sticking the adhesive layer 12, as formed by directly applying a solution of the adhesive composition onto the substrate 11, to the release surface of the release material 13.

The adhesive sheet 1d in which the adhesive layer 12 is sandwiched between two release materials not using a substrate, as in Fig. 1(d), can be produced, for example, by sticking the adhesive layer 12, as formed by directly applying a solution of the adhesive composition onto the release surface of the release material 13a, to the release material 13b. The adhesive sheet of the type may also be produced as a one-layer tape-like, substrateless double-sided adhesive tape, by directly applying a solution of the adhesive composition onto one side of a release material processed for lubrication on both surfaces thereof, followed by winding up into a roll. As described above, it is desirable that the release material 13a and the release material 13b differ in point of the peel force thereof.

The solid concentration of the solution of the adhesive composition prepared by adding an organic solvent to the composition is preferably from 10 to 60% by mass, more preferably from 12 to 45% by mass, even more preferably from 15 to 30% by mass.

After the solution of the adhesive composition prepared by dissolving the composition in an organic solvent has been applied onto the substrate or onto the release surface of the release material, it is desirable that the coated substrate or release material is heated at a temperature of from 80 to 150°C for 30 seconds to 5 minutes for preventing the solvent and any low-boiling point component from remaining on the coated surface.

The thickness of the adhesive layer of the adhesive sheets (I) and (II) may be suitably determined depending on the use of the sheets, and is preferably from 0.5 to 100 µm, more preferably from 1 to 60 µm, even more preferably from 3 to 40 µm. When the thickness is at least 0.5 µm, then the sheets secures good adhesion force to adherends; and when at most 100 µm, then the adhesive sheets are advantageous in point of productivity and are handleable with ease.

### [Use of Adhesive Sheets (I) and (II) of the Invention]

The adhesive sheets (I) and (II) of the present invention have excellent adhesion force and secure a good balance between adhesion force and retention force, irrespective of the type of adherends, and in addition, the sheets can prevent occurrence of zipping, have a low moisture vapor transmission rate, is excellent in transparency and can lower the amount of outgas generation. Further, the sheets exhibit excellent resistance to high wet heat and UV ray. Accordingly, the adhesive sheets (I) and (II) of the present invention are favorable for sealing parts.

As sealing parts, the sheets can be used for electronic devices, for example, organic devices such as organic transistors, organic memories, organic EL elements, etc.; liquid-crystal displays; electronic papers; thin-film transistors; electrochromic devices; electrochemical light-emitting devices; touch panels; solar cells; thermoelectric conversion devices; piezoelectric transducer devices; energy storage devices; etc.

Of those, the adhesive sheets (I) and (II) of the present invention are favorably used for sealing up organic EL elements.

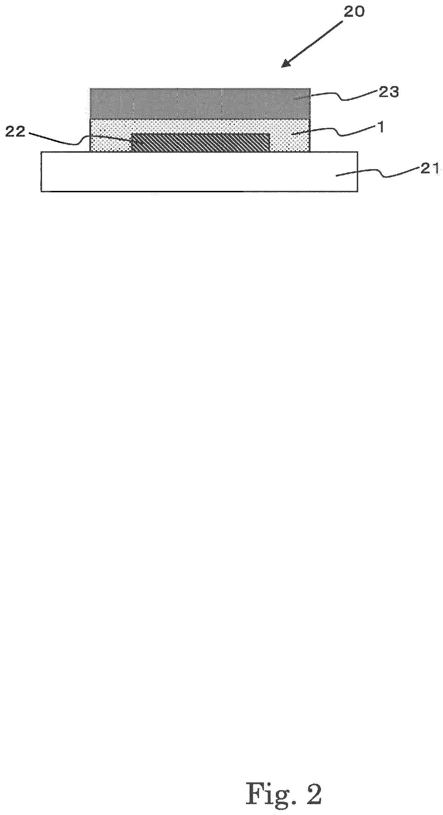

Fig. 2 shows one example of an organic EL element sealed up with the adhesive sheet (I) or (II) of the present invention. Sealing up of an organic EL element is described below; however, the adhesive sheets (I) and (II) of the present invention are, not limited to organic devices such as organic EL elements and others, favorably usable for sealing up other various electronic devices such as those mentioned above.

The organic EL element 20 has a structure 22 formed on a glass substrate 21. The structure 22 comprises a transparent electrode, a hole transport layer, a light-emitting layer, a back electrode and the like, as laminated on the substrate. The adhesive sheet 1 of the present invention is laminated on the structure 22 and the glass substrate 21, and further, the gas barrier film 23 is fixed on the adhesive sheet 1. The adhesive layer of the adhesive sheet 1 of the present invention is airtightly stuck and fixed to the structure 22 and the glass substrate 21 to give the sealed organic EL element 20. When the adhesive sheet of the present invention is used, the organic EL element can be sealed up in a simplified manner, not requiring any treatment of heating at high temperatures or UV irradiation, etc.

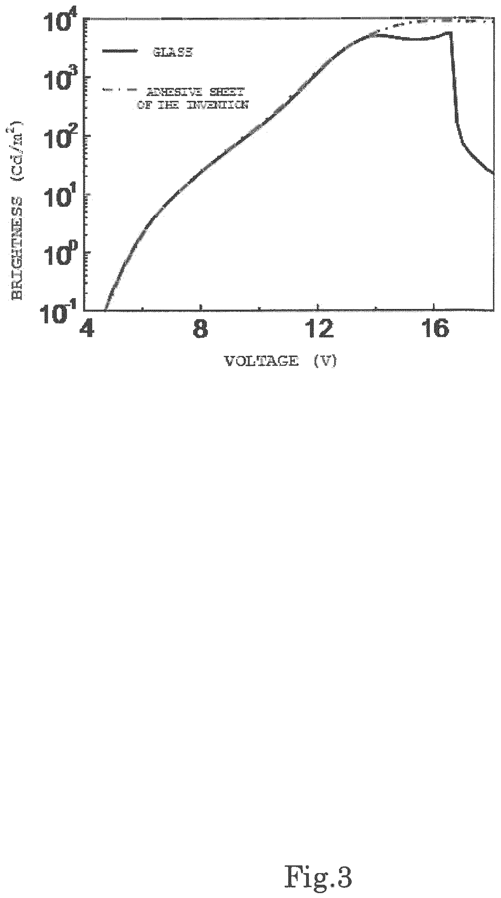

The characteristics of the organic EL element sealed up with the adhesive sheet (I) or (II) of the present invention are described with reference to Fig. 3. Fig. 3 shows a relationship between the voltage and the brightness of the organic EL element sealed up with the adhesive sheet of the present invention or with glass. In the organic EL element sealed up with glass, the structure generates heat with increase in the voltage applied thereto, and the element is broken by the heat and the brightness is thereby lowered. On the other hand, the adhesive sheet of the present invention can effuse the heat generated by the structure out of the element, and therefore, even though the voltage given to the element has increased, the brightness from the element can be prevented from lowering.

### Example

The weight-average molecular weight (Mw) and the softening point of the components used in the following Examples and Comparative Examples were measured according to the methods mentioned below.

### <Weight-Average Molecular Weight (Mw)>

Using a gel permeation chromatography apparatus (trade name "HLC-8020" by manufactured Tosoh Corporation), the sample was analyzed under the condition mentioned below to measure the standard polystyrene-equivalent, weight-average molecular weight thereof.

### (Measurement Condition)

Columns: "TSK Guard Column HXL-H", "TSK Gel GMHXL (×2)", "TDK Gel G2000HXL" (all by manufactured Tosoh Corporation)
Column temperature: 40°C
Developing solvent: tetrahydrofuran
Flow rate: 1.0 mL/min

### <Softening Point>

Measured according to JIS K 2531.

Physical properties of the adhesive compositions and the adhesive sheets obtained in the following Examples and Comparative Examples were measured and evaluated according to the methods mentioned below.

### <Adhesion Force>

The adhesive sheet produced in Examples and Comparative Examples was cut into a size of 25 mm × 300 mm, and in an environment at 23°C and 50% RH (relative humidity), the light release sheet was peeled off, and the adhesive sheet was stuck to the adherend mentioned below. In sticking the sheet, a roller having a weight of 2 kg was used. The roller was moved once back and forth on the sheet to thereby stick the sheet to the adherend. After thus stuck, this was left in an environment at 23°C and 50% RH for 24 hours, and then also in the same environment, the sheet was peeled off from the adherend, using a tensile tester (trade name "Tensilon" manufactured by Orientec Corporation) at a peel rate of 300 mm/min and at a peel angle of 180°, and the adhesion force (N/25 mm) of the sample was thus measured.

The adherend used in the measurement of the adhesion force was as follows (the code in the bracket [] is the abbreviation in Tables 1 to 3).
- Stainless plate [SUS]: SUS304 steel plate, #280 polished.
- Aluminium-deposited surface [Al] : trade name "FNS Luster 25PET(l)" manufactured by Lintec Corporation), aluminium-deposited surface of aluminium-deposited polyethylene terephthalate.
- Polyethylene terephthalate [PET]: trade name "Lumirror" manufactured by Toray Industries, Inc., having a thickness of 50 µm.
- Soda lime glass [glass]: trade name "Corning Glass Eagle XG" manufactured by NSG Precision Co, ltd., 150 mm × 70 mm × 2 mm.
- ITO-deposited surface [ITO]: ITO-deposited surface of polyethylene terephthalate coated with tin-doped indium oxide (ITO) through vapor deposition thereon.

### <Presence or Absence of Zipping>

In the adhesion force measurement where the above-mentioned stainless plate [SUS] was used as the adherend, the presence or absence of occurrence of zipping was observed visually. The samples with no occurrence of zipping were given A; and those with occurrence of zipping were given F.

### <Retention Force>

The adhesive sheet produced in Examples and Comparative Examples was cut into a size of 25 mm × 100 mm, and in an environment at 23°C and 50% RH (relative humidity), stuck to a stainless plate (SUS304 steel plate, #360 polished) in such a manner that the stuck area could be 25 mm × 25 mm. In sticking the sheet, a roller having a weight of 2 kg was used. The roller was moved five times back and forth on the sheet to thereby stick the sheet to the adherend. After thus stuck, this was left as such for 20 minutes, and then transferred into an oven at a temperature of 40°C, in which a weight of 1 kg was applied thereto in such a manner that the load could be given to the adhesive sheet in the vertical direction thereof. While thus left in the oven, the elapsed time (second) taken during slipping down of the adhesive sheet to complete peeling thereof from the adherend was counted. However, in a case where the adhesive sheet did not still completely peel off even after 70000 seconds, the slipping length (mm) of the sheet was measured. The samples that took a longer time for peeling off and those that had a shorter slipping length are more excellent in retention force.

### <Moisture Vapor Transmission Rate>

A solution of the adhesive composition prepared in Examples and Comparative Examples was applied onto a polyethylene terephthalate film (trade name "SP-PET38T103-1" manufactured by Lintec Corporation, having a thickness of 38 µm), which had been processed for silicone lubrication on the surface thereof as a heavy release sheet, in such a manner that the dry thickness of the coating layer could be 50 µm, and then dried at 120°C for 2 minutes to form an adhesive layer thereon. On the surface of the thus-formed adhesive sheet, the lubrication-processed surface of a polyethylene terephthalate film (trade name "SP-PET381130" manufactured by Lintec Corporation, having a thickness of 38 µm), which had been processed for silicone lubrication on the surface thereof as a light release sheet, was stuck, thereby producing a substrateless adhesive sheet sandwiched between two release sheets.

The two release sheets were peeled from the adhesive sheet, and the surface of the thus-exposed adhesive layer was laminated with a polyethylene terephthalate film (manufactured by Mitsubishi Plastics, Inc. , having a thickness of 6 µm), thereby preparing a sample for moisture vapor transmission rate measurement, in which the adhesive layer was sandwiched between two polyethylene terephthalate film.

For the moisture vapor transmission rate measurement, a moisture vapor transmission rate measurement system (trade name "L89-500" manufactured by LYSSY Corporation) was used, and the sample was analyzed in an environment at 40°C and 90% RH (relative humidity). The moisture vapor transmission rate of the two polyethylene terephthalate films used for lamination was 43 g/m²/day. In other words, when the moisture vapor barrier performance of the adhesive layer is completely zero, then the moisture vapor transmission rate thereof could be around 43 g/m²/day. The samples having a lower value are better in point of the moisture vapor barrier performance of the adhesive layer therein.

### <Visible Light Transmittance>

The light release sheet was peeled from the substrateless adhesive sheet sandwiched between two release sheets, which was the same one as that used in the moisture vapor transmission rate measurement, and the surface of the thus-exposed adhesive layer was laminated with a glass plate (trade name "Corning Glass Eagle XG" manufactured by NSG Precision Co, ltd. , 150 mm × 70 mm × 2 mm), and then the heavy release sheet was peeled thereby providing a glass plate-attached adhesive sheet of which one side of the adhesive layer was exposed. Using a visible light transmittance measuring apparatus (trade name "UV-3101PC" manufactured by Shimadzu Corporation), the visible light transmittance at a wavelength of 550 nm of the glass plate-attached adhesive sheet was measured.

### <Degree of Yellowness>

The light release sheet was peeled from the substrateless adhesive sheet sandwiched between two release sheets, which was the same one as that used in the moisture vapor transmission rate measurement, and the surface of the thus-exposed adhesive layer was laminated with a glass plate (trade name "Corning Glass Eagle XG" manufactured by NSG Precision Co, ltd. , 150 mm × 70 mm × 2 mm), and then the heavy release sheet was peeled thereby providing a glass plate-attached adhesive sheet of which one side of the adhesive layer was exposed. The prepared sample was left in a dry environment at 80°C for 8 weeks, and then, using a visible light transmittance measuring apparatus (trade name "UV-3101PC" manufactured by Shimadzu Corporation), the visible light transmittance at a wavelength of from 1000 to 300 nm of the sample was measured. From the found data of the light transmittance, the degree of yellowness of the sample was calculated using software "UV-Prove" manufactured by Shimadzu Corporation.

### <Outgas Generation Amount>

The substrateless adhesive sheet sandwiched between two release sheets, which was the same one as that used in the moisture vapor transmission rate measurement, was cut into a size of 20 cm². Subsequently, the two release sheets were peeled off, and the adhesive sheet of which both sides were exposed was put into an ampoule and sealed up. Using Purge & Trap GC Mass (trade name "JHS-100A" manufactured by JEOL Ltd.), the ampoule was heated at 120°C for 30 minutes, and the generated gas was collected. Subsequently, the gas was introduced into GC Mass (trade name "Turbo Mass" manufactured by PERKIN ELMER Inc.), and the generated gas amount was measured as n-decane-equivalent amount (µg/cm²) based on the calibration curve formed with n-decane.

### [Examples 1a to 13a, Comparative Examples 1a to 15a]

The polyisobutylene resin (above-mentioned component (B) or its substitution) and the hydrogenated petroleum resin or terpene resin (above-mentioned component (C) or its substitution), of which the type and the mass ratio (solid ratio) are shown in Table 1 relative to 100 parts by mass (solid content) of the polyisobutylene-based resin shown in Table 1 (above-mentioned component (A) or its substitution), were dissolved in toluene to prepare a solution of an adhesive composition having a solid concentration of 20% by mass.

Next, using a polyethylene terephthalate film (trade name "COSMOSHINE A4100" manufactured by Toyobo Co., Ltd., having a thickness of 50 µm) as a substrate, the thus-prepared solution of adhesive composition was applied onto the substrate in such a manner that the dry thickness of the coating layer could be 20 µm, and then dried at 120°C for 2 minutes to form an adhesive layer thereon. Next, the lubrication-processed surface of a polyethylene terephthalate film (trade name "SP-PET381130" manufactured by Lintec Corporation, having a thickness of 38 µm), which had been processed for silicone lubrication on the surface thereof as a light release sheet, was stuck to the surface of the formed adhesive layer, thereby providing an adhesive sheet.

The details of the components used in Examples 1a to 13a and Comparative Examples 1a to 15a in Tables 1 and 2 are as follows:
Component (A) and its substitution:
   Oppanol B50 (trade name, manufactured by BASF), having a weight-average molecular weight of 340,000.
   Oppanol B80 (trade name, manufactured by BASF), having a weight-average molecular weight of 800,000.
Component (B) and its substitution:
   Oppanol B30 (trade name, manufactured by BASF), having a weight-average molecular weight of 200,000.
   Oppanol B10 (trade name, manufactured by BASF), having a weight-average molecular weight of 36,000.
Component (C) and its substitution:
   Alcon P-100 (trade name, manufactured by Arakawa Chemical Industries, Ltd.), hydrogenated petroleum resin having a softening point of 100°C.
   Alcon P-115 (trade name, manufactured by Arakawa Chemical Industries, Ltd.), hydrogenated petroleum resin having a softening point of 115°C.
   Alcon P-125 (trade name, manufactured by Arakawa Chemical Industries, Ltd.), hydrogenated petroleum resin having a softening point of 125°C.
   Alcon P-140 (trade name, manufactured by Arakawa Chemical Industries, Ltd.), hydrogenated petroleum resin having a softening point of 140°C.
   Clearon P-125 (trade name, manufactured by Yasuhara Chemical Co., Ltd.), terpene resin having a softening point of 125°C.
   Clearon P-150 (trade name, manufactured by Yasuhara Chemical Co., Ltd.), terpene resin having a softening point of 150°C.

### [Comparative Example 16a]

100 parts by mass (solid content) of styrene-isobutene-styrene block copolymer (trade name "Quintac 3421" manufactured by Nippon Zeon Corporation, having a styrene content of 14% and Mw of 120,000) was dissolved in toluene to prepare a solution of an adhesive composition having a solid concentration of 20% by mass.

Next, using the thus-obtained solution of adhesive composition, an adhesive sheet was produced in the same manner as above.

### [Comparative Example 17a]

As monomer components, 90 parts by mass of butyl acrylate and 10 parts by mass of acrylic acid, and as a polymerization initiator, 0.2 parts by mass of azobisisobutyronitrile were put into a reactor and mixed therein. This was purged with nitrogen gas for 4 hours, then gradually heated up to 60°C, and polymerized with stirring for 24 hours, thereby preparing an acrylic copolymer (weight-average molecular weight, 650,000)-containing ethyl acetate solution (solid concentration, 33% by mass).

1.5 parts by mass (solid ratio) of an isocyanate-type crosslinking agent (ethyl acetate solution of trade name "Coronate L" manufactured by Nippon Polyurethane Industry Co., Ltd., trimethylolpropane-modified tolylene diisocyanate, having a solid content of 75% by mass) was added to 100 parts by mass (solid content) of the above-obtained, acrylic copolymer-containing ethyl acetate solution, and dissolved in toluene to prepare a solution of an adhesive composition having a solid concentration of 20% by mass.

Next, using the thus-obtained solution of adhesive composition, an adhesive sheet was produced in the same manner as above.

Physical properties of the adhesive compositions and the adhesive sheets obtained in the above-mentioned Examples 1a to 13a and Comparative Examples 1a to 17a were measured according to the above-mentioned methods, and the results are shown in Tables 1 and 2.

It is known that the adhesive sheets of Examples 1a to 13a in Table 1 are excellent in the balance between the adhesion force and the retention force thereof and have a high visible light transmittance, and that the moisture vapor transmission rate and the outgas generation amount thereof are both extremely low.

On the other hand, some adhesive sheets of Comparative Examples 1a to 15a in Table 2 have poor adhesion force to some adherends, and even though the comparative adhesive sheets are excellent in adhesion force, the balance between the adhesion force and the retention force thereof is inferior to that of Examples. In addition, especially, the adhesive sheets of Comparative Examples 16a and 17a have a high moisture vapor transmission rate and are therefore unfavorable for sealing up organic EL elements, etc.
[Table 1]

**Table 1**

| | | Mw or Softening Point | Example 1a | Example 2a | Example 3a | Example 4a | Example 5a | Example 6a | Example 7a | Example 8a | Example 9a | Example 10a | Example 11a | Example 12a | Example 13a |
|---|---|---|---|---|---|---|---|---|---|---|---|---|---|---|---|
| Component (A) * | Oppanol B50 | Mw: 340,000 | 100 | 100 | 100 | 100 | 100 | 100 | 100 | 100 | 100 | 100 | 100 | 100 | 100 |
| Component (B) * | Oppanol B30 | Mw: 200,000 | 10 | 10 | 10 | 10 | 10 | 10 | 10 | 25 | 50 | 10 | 10 | 10 | 50 |
| Component (C) * | Alcon P-100 | softening point: 100°C | 20 | - | - | 30 | - | - | - | 30 | 30 | 15 | 15 | - | 15 |
| | Alcon P-115 | softening point: 115°C | - | 20 | - | - | 30 | - | 50 | - | - | 15 | - | 15 | - |
| | Alcon P-125 | softening point: 125°C | - | - | 20 | - | - | 30 | - | - | - | - | 15 | 15 | - |
| Adhesion Force (N/25 mm) | | SUS | 16.6 | 19.4 | 19.2 | 23.0 | 23.3 | 20.7 | 31.3 | 14.4 | 14.9 | 23.5 | 20.5 | 23.8 | 14.0 |
| | | Al | 12.7 | 17.3 | 17.4 | 15.2 | 20.0 | 20.4 | 25.2 | 5.6 | 5.1 | 19.0 | 19.2 | 20.2 | 5.2 |
| | | PET | 12.3 | 18.2 | 19.0 | 20.4 | 20.2 | 20.8 | 18.6 | 8.4 | 7.4 | 20.5 | 20.7 | 20.7 | 7.4 |
| | | Glass | 15.1 | 14.5 | 12.4 | 12.6 | 15.8 | 7.5 | 25.7 | 6.2 | 10.4 | 13.6 | 10.3 | 8.3 | 6.0 |
| | | ITO | 6.3 | 11.1 | 8.1 | 5.4 | 6.1 | 5.8 | 2.8 | 6.3 | 7.3 | 6.8 | 4.8 | 6.4 | 5.4 |
| Presence of Absence of Zipping | | SUS | A | A | A | A | A | A | A | A | A | A | A | A | A |
| Retention Force (mm or sec) | | SUS 40°C, 1 kgf | 3.0 mm | 1.8 mm | 2.0 mm | 2.4 mm | 3.0 mm | 3.0 mm | 3.2 mm | 3.2 mm | 3.7 mm | 3.4 mm | 3.2 mm | 2.7 mm | 3.8 mm |
| Moisture Vapor Transmission Rate (g/m²/day) | | | 3.3 | 3.1 | 3.5 | 3.2 | 3.4 | 3.3 | 3.8 | 3.9 | 3.5 | 3.2 | 4.0 | 3.1 | 3.5 |
| Visible Light Transmittance (%) | | | 91 | 91 | 91 | 91 | 91 | 91 | 91 | 91 | 91 | 91 | 91 | 91 | 91 |
| Degree of Yellowing (-) | | | 0.1 | 0.1 | 0.1 | 0.2 | 0.2 | 0.2 | 0.3 | 0.2 | 0.2 | 0.2 | 0.2 | 0.2 | 0.2 |
| Outgas Generation Amount ((g/cm²) | | | 0.1 | 0.1 | 0.1 | 0.1 | 0.1 | 0.1 | 0.2 | 0.1 | 0.1 | 0.1 | 0.1 | 0.1 | 0.1 |

| | | | | | | | | | | | | | | | |
|---|---|---|---|---|---|---|---|---|---|---|---|---|---|---|---|
| * The amount of each component is in terms of "part by mass" based on the solid content. | | | | | | | | | | | | | | | |

[Table 2]

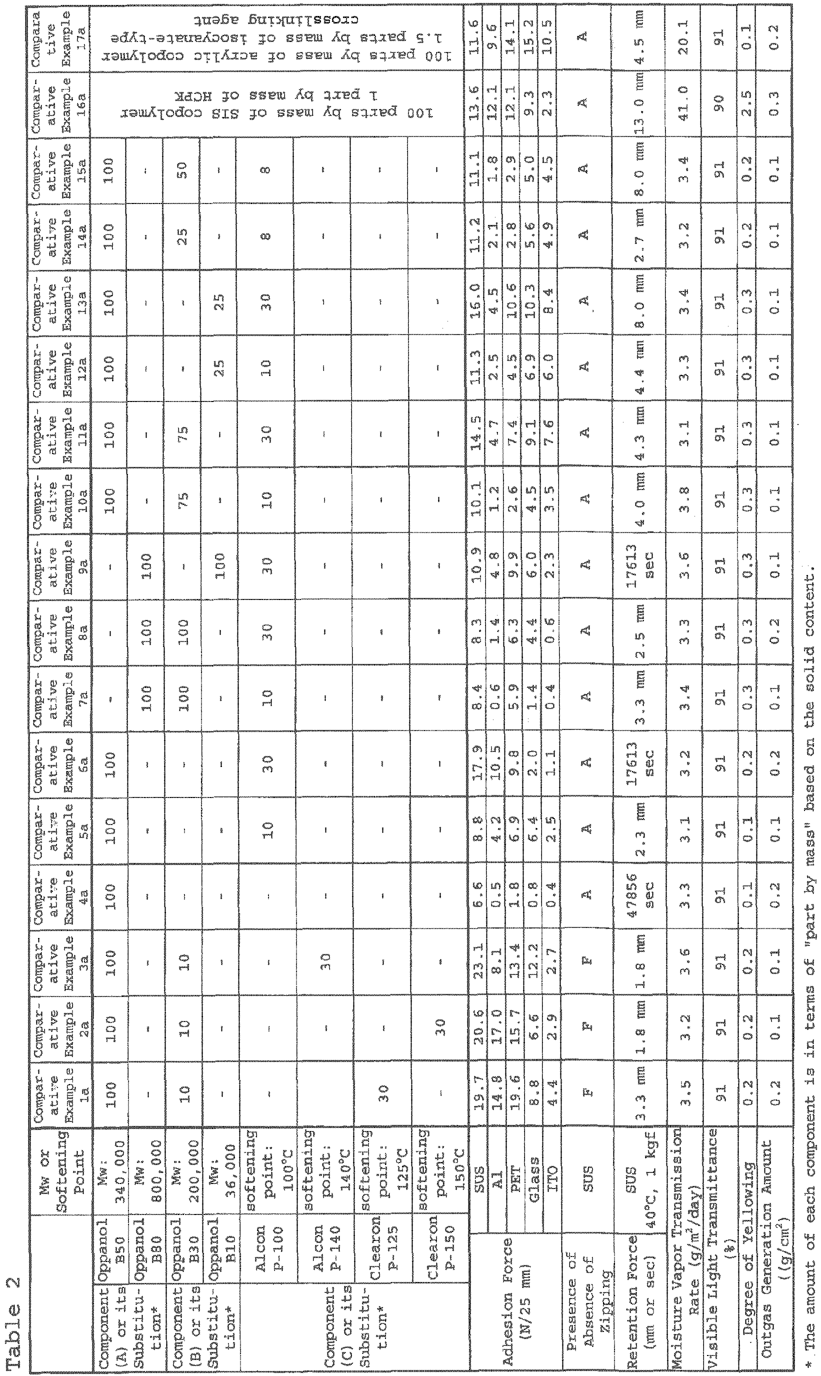

### [Examples 1b to 5b, Comparative Examples 1b to 4b]

The polyisobutylene resin (above-mentioned component (B') or its substitution) and the hydrogenated petroleum resin or terpene resin (above-mentioned component (C') or its substitution), of which the type and the mass ratio (solid ratio) are shown in Table 3 relative to 100 parts by mass (solid content) of the polyisobutylene-based resin shown in Table 3 (above-mentioned component (A') or its substitution), were dissolved in toluene to prepare a solution of an adhesive composition having a solid concentration of 20% by mass.

Next, using a polyethylene terephthalate film (trade name "COSMOSHINE A4100" manufactured by Toyobo Co., Ltd., having a thickness of 50 µm) as a substrate, the thus-prepared solution of adhesive composition was applied onto the substrate in such a manner that the dry thickness of the coating layer could be 20 µm, and then dried at 120°C for 2 minutes to form an adhesive layer thereon. Next, the lubrication-processed surface of a polyethylene terephthalate film (trade name "SP-PET381130" manufactured by Lintec Corporation, having a thickness of 38 µm), which had been processed for silicone lubrication on the surface thereof as a light release sheet, was stuck to the surface of the formed adhesive layer, thereby providing an adhesive sheet.

The details of the components used in Examples 1b to 5b and Comparative Examples 1b to 4b in Table 3 are as follows:
Component (A') and its substitution:
   Oppanol B50 (trade name, manufactured by BASF), having a weight-average molecular weight of 340,000.
   Oppanol B80 (trade name, manufactured by BASF), having a weight-average molecular weight of 800,000.
Component (B'):
   Oppanol B30 (trade name, manufactured by BASF), having a weight-average molecular weight of 200,000.
Component (C') and its substitution:
   Alcon P-100 (trade name, manufactured by Arakawa Chemical Industries, Ltd.), hydrogenated petroleum resin having a softening point of 100°C.
   Alcon P-115 (trade name, manufactured by Arakawa Chemical Industries, Ltd.), hydrogenated petroleum resin having a softening point of 115°C.
   Alcon P-125 (trade name, manufactured by Arakawa Chemical Industries, Ltd.), hydrogenated petroleum resin having a softening point of 125°C.
   Alcon P-140 (trade name, manufactured by Arakawa Chemical Industries, Ltd.), hydrogenated petroleum resin having a softening point of 140°C.
   Clearon P-125 (trade name, manufactured by Yasuhara Chemical Co., Ltd.), terpene resin having a softening point of 125°C. Clearon P-150 (trade name, manufactured by Yasuhara Chemical Co., Ltd.), terpene resin having a softening point of 150°C.

The probe tack in Table 3 was measured according to the method mentioned below.

### <Probe Tack>

The adhesive sheet produced in Examples 1b to 5b and Comparative Examples 1b to 4b was cut into a size of 25 mm × 25 mm to prepare a sample for measurement. In an environment at 23°C and 50% RH (relative humidity) and using a probe tack measuring apparatus (trade name "PROBE TACK TESTER Model RPT100" manufactured by RHESCA Corporation), the sample was analyzed according to "JIS Z0237:1991, Reference 5". Concretely, the release sheet was peeled from the sample for measurement, and a stainless probe having a diameter of 5 mm was kept in contact with the surface of the exposed adhesive layer at a contact load of 0.98 N/cm² for one second, then the probe was separated from the sample at a rate of 600 mm/min, and the peel force for the separation was measured. Of the probe tack measured with the increase in the travel distance of the probe, the maximum value detected first was referred to as "first maximum value P1" and the maximum value detected secondarily was referred to as "second maximum value P2".

For the chart of the probe tack measured according to the above-mentioned method, the chart of the probe tack of the adhesive sheet of Example 1b is shown in Fig. 4.

Physical properties of the adhesive compositions and the adhesive sheets obtained in the above-mentioned Examples 1b to 5b and Comparative Examples 1b to 4b were measured according to the above-mentioned methods, and the results are shown in Table 3.

It is known that the adhesive sheets of Examples 1b to 5b are excellent in the balance between the adhesion force and the retention force thereof, are free from zipping, have a high visible light transmittance, have a low degree of yellowness and are excellent in transparency. In addition, it is known that the moisture vapor transmission rate and the outgas generation amount of these adhesive sheets are both extremely low.

On the other hand, some adhesive sheets of Comparative Examples 1b to 4b have poor adhesion force to some adherends, and even though the comparative adhesive sheets are excellent in adhesion force, their retention force is low and the balance between the adhesion force and the retention force of these comparative adhesive sheets is inferior to that of the adhesive sheets of Examples. In addition, zipping occurred with the adhesive sheets of Comparative Examples 1b to 3b.
[Table 3]

**Table 3**

| | | | | | Example 1b | Example 2b | Example 3b | Example 4b | Example 5b | Comparative Example 1b | Comparative Example 2b | Comparative Example 3b | Comparative Example 4b |
|---|---|---|---|---|---|---|---|---|---|---|---|---|---|
| Found Data of Probe Tack | | First Maximum Value P1 (N) | | | 7.0 | 6.5 | 6.0 | 6.0 | 5.0 | 6.0 | 7.0 | 3.0 | 3.0 |
| | | Second Maximum Value P2 (N) | | | 5.0 | 4.0 | 2.5 | 3.0 | 3.0 | 1.0 | 1.5 | 0 | 2.0 |
| | | P2/P1 | | | 0.71 | 0.62 | 0.42 | 0.50 | 0.60 | 0.17 | 0.21 | 0.00 | 0.67 |
| Component (A') or its Substitution* | Oppanol B50 | | Mw, 340,000 | | 100 | 100 | 100 | 100 | 100 | 100 | 100 | 100 | - |
| | Oppanol B80 | | Mw, 800,000 | | - | - | - | - | - | - | - | - | 100 |
| Component (B') * | Oppanol B30 | | Mw, 200,000 | | 10 | 10 | 10 | 10 | 10 | 10 | 10 | 10 | 100 |
| Component (C') or its Substitution* | Alcon P-100 | | softening point, 100°C | | 20 | - | - | - | - | - | - | - | 30 |
| | Alcon P-115 | | softening point, 115°C | | - | 20 | - | 30 | - | - | - | - | - |
| | Alcon P-125 | | softening point, 125°C | | - | - | 20 | - | 50 | - | - | - | - |
| | Alcon P-140 | | softening point, 140°C | | - | - | - | - | - | - | - | 30 | - |
| | Clearon P-125 | | softening point, 125°C | | - | - | - | - | - | 30 | - | - | - |
| | Clearon P-150 | | softening point, 150°C | | - | - | - | - | - | - | 30 | - | - |
| Adhesion Force (N/25 mm) | | | | SUS | 16.6 | 19.4 | 19.2 | 23.3 | 33.4 | 19.7 | 20.6 | 23.1 | 8.3 |
| | | | | Al | 12.7 | 17.3 | 17.4 | 20.0 | 22.3 | 14.8 | 17.0 | 8.1 | 1.4 |
| | | | | PET | 12.3 | 18.2 | 19.0 | 20.2 | 16.0 | 19.6 | 15.7 | 13.4 | 6.3 |
| | | | | Glass | 15.1 | 14.5 | 12.4 | 15.8 | 13.2 | 8.8 | 6.6 | 12.2 | 4.4 |
| | | | | ITO | 6.3 | 7.1 | 8.1 | 6.1 | 2.0 | 4.4 | 2.9 | 2.7 | 0.6 |
| Presence or Absence of Zipping | | | | SUS | A | A | A | A | A | F | F | F | A |
| Retention Force (sec or mm) | | | | 40°C, 1 kgf | 3.0 mm | 1.8 mm | 2.0 mm | 3.0 mm | 5.0 mm | 3.3 mm | 1.8 mm | 1.8 mm | 2.5 mm |
| Moisture Vapor Transmission Rate (g/m²/day) | | | | | 5.0 | 5.0 | 5.0 | 5.0 | 5.0 | 5.0 | 5.0 | 5.0 | 5.0 |
| Visible Light Transmittance (%) | | | | | 91 | 91 | 91 | 91 | 90 | 91 | 91 | 91 | 91 |
| Degree of Yellowness | | | | | 0.1 | 0.1 | 0.1 | 0.2 | 0.2 | 0.2 | 0.2 | 0.2 | 0.3 |
| Outgas Generation Amount (µg/cm²) | | | | | 0.1 | 0.1 | 0.1 | 0.1 | 0.1 | 0.2 | 0.1 | 0.1 | 0.2 |

| | | | | | | | | | | | | | |
|---|---|---|---|---|---|---|---|---|---|---|---|---|---|
| * The amount of each component is in terms of "part by mass" based on the solid content. | | | | | | | | | | | | | |

### Industrial Applicability

As sealing parts, the adhesive sheets of the present invention can be used for electronic devices, for example, organic devices such as organic transistors, organic memories, organic EL elements, etc. ; liquid-crystal displays; electronic papers; thin-film transistors; electrochromic devices; electrochemical light-emitting devices; touch panels; solar cells; thermoelectric conversion devices; piezoelectric transducer devices; energy storage devices; etc.

In addition, the adhesive sheets of the present invention are applicable for use as temporary fixation adhesive sheets for temporarily fixing an electronic material having thereon a gas barrier film such as a silicon nitride film, a silicon oxide film or the like or an electroconductive film, on a glass plate or on a substrate or the like, before treatment of etching treatment, washing treatment, thermal treatment, photoexposure treatment, energy ray irradiation treatment or the like in a process of producing electronic parts. Reference Signs List

1, 1a, 1b, 1c, 1d Adhesive Sheet
11 Substrate
12, 12a, 12b Adhesive Layer
13, 13a, 13b Release Material
20 Organic EL Element
21 Glass Substrate
22 Structure
23 Gas Barrier Film

## Claims

1. An adhesive composition comprising a polyisobutylene-based resin (A) having a weight-average molecular weight of from 270,000 to 480,000, a polyisobutylene-based resin (B) having a weight-average molecular weight of from 100,000 to 250,000, and a hydrogenated petroleum resin (C) having a softening point of from 90 to 135°C; which contains, relative to 100 parts by mass of the polyisobutylene-based resin (A) therein, the polyisobutylene-based resin (B) in an amount of from 5 to 55 parts by mass and the hydrogenated petroleum resin (C) in an amount of from 10 to 55 parts by mass;
provided that the composition is different from Manufacturing Examples D and E of EP 2 615 144 A1.

2. The adhesive composition according to claim 1, wherein the hydrogenated petroleum resin (C) is at least one or more selected from a group consisting of a hydrogenated resin of a C5 petroleum resin obtained through copolymerization of a C5 fraction, a hydrogenated resin of a C9 petroleum resin obtained through copolymerization of a C9 fraction, and a hydrogenated resin of a copolymerized petroleum resin of a C5 fraction and a C9 fraction.

3. An adhesive sheet having an adhesive layer of the adhesive composition of claim 1 or 2.

4. An adhesive sheet having at least one adhesive layer, wherein the adhesive layer is formed of an adhesive composition that comprises a polyisobutylene-based resin (A') having a weight-average molecular weight of from 270,000 to 480,000, a polyisobutylene-based resin (B') having a weight-average molecular weight of from 100,000 to 250,000, and a hydrogenated petroleum resin (C') having a softening point of from 90 to 135°C,
provided that the composition is different from Manufacturing Examples D and E of EP 2 615 144 A1,
and wherein.
the probe tack of the adhesive layer, as measured at a peel rate of 600 mm/min according to JIS-Z0237 (1991), has two maximum values and wherein the first maximum value P1 detected first is at least 4.0 N and the ratio of the second maximum value P2 detected secondarily to the first maximum value P1 [P2/P1] is from 0.25 to 1.50.

5. The adhesive sheet according to claim 4, wherein the adhesive composition contains, relative to 100 parts by mass of the polyisobutylene-based resin (A') therein, the polyisobutylene-based resin (B') in an amount of from 5 to 55 parts by mass and the hydrogenated petroleum resin (C') in an amount of 10 to 55 parts by mass.

6. The adhesive sheet according to claim 5, wherein the hydrogenated petroleum resin (C') is at least one or more selected from a group consisting of a hydrogenated resin of a C5 petroleum resin obtained through copolymerization of a C5 fraction, a hydrogenated resin of a C9 petroleum resin obtained through copolymerization of a C9 fraction, and a hydrogenated resin of a copolymerized petroleum resin of a C5 fraction and a C9 fraction.

7. The adhesive sheet according to any of claims 3 to 6, wherein the visible light transmittance at a wavelength of 550 nm of the adhesive layer having a thickness of 50 µm is at least 90%.

8. The adhesive sheet according to any of claims 3 to 7, wherein the moisture vapor transmission rate at 40°C and at a relative humidity of 90% of the adhesive layer having a thickness of 50 µm is at most 10 g/m²/day.

9. The adhesive sheet according to any of claims 3 to 8, which has a configuration of such that the adhesive layer is sandwiched between two release materials not using a substrate.

10. The adhesive sheet according to any of claims 3 to 9, which is used for sealing up organic electroluminescence (EL) elements.

## Patentansprüche

1. Klebstoffzusammensetzung, umfassend ein Harz auf Polyisobutylenbasis (A) mit einem gewichtsmittleren Molekulargewicht von 270.000 bis 480.000, ein Harz auf Polyisobutylenbasis (B) mit einem gewichtsmittleren Molekulargewicht von 100.000 bis 250.000, und ein hydriertes Petroleumharz (C) mit einem Erweichungspunkt von 90 bis 135 °C; welche bezogen auf 100 Massenteile des Harzes auf Polyisobutylenbasis (A) das Harz auf Polyisobutylenbasis (B) in einer Menge von 5 bis 55 Massenteilen und das hydrierte Petroleumharz (C) in einer Menge von 10 bis 55 Massenteilen enthält, vorausgesetzt dass die Zusammensetzung von den Herstellungsbeispielen D und E der EP 2 615 144 A1 unterschiedlich ist.

2. Klebstoffzusammensetzung gemäß Anspruch 1, worin das hydrierte Petroleumharz (C) mindestens eines oder mehrere ausgewählt aus einer Gruppe bestehend aus einem hydrierten Harz eines C5-Petroleumharzes, erhalten durch Copolymerisation einer C5-Fraktion, einem hydrierten Harz eines C9-Petroleumharzes, erhalten durch Copolymerisation einer C9-Fraktion, und einem hydrierten Harz eines copolymerisierten Petroleumharzes einer C5-Fraktion und einer C9-Fraktion ist.

3. Klebefolie mit einer Klebeschicht der Klebstoffzusammensetzung gemäß Anspruch 1 oder 2.

4. Klebefolie mit mindestens einer Klebeschicht, worin die Klebeschicht aus einer Klebstoffzusammensetzung gebildet ist, die ein Harz auf Polyisobutylenbasis (A') mit einem gewichtsmittleren Molekulargewicht von 270.000 bis 480.000, ein Harz auf Polyisobutylenbasis (B') mit einem gewichtsmittleren Molekulargewicht von 100.000 bis 250.000 und ein hydriertes Petroleumharz (C') mit einem Erweichungspunkt von 90 bis 135 °C umfasst, vorausgesetzt dass die Zusammensetzung von den Herstellungsbeispielen D und E der EP 2 615 144 A1 unterschiedlich ist,
und worin
die Sondenklebrigkeit der Klebstoffschicht, gemessen bei einer Schälrate von 600 mm / min gemäß JIS-Z0237 (1991), zwei Maximalwerte aufweist und wobei der erste zuerst detektierte Maximalwert P1 mindestens 4,0 N und das Verhältnis [P2 / P1] des zweiten als zweites detektierten Maximalwertes P2 zum ersten Maximalwert P1 0,25 bis 1,50 beträgt.

5. Klebefolie gemäß Anspruch 4, worin die Klebstoffzusammensetzung bezogen auf 100 Massenteile des Harzes auf Polyisobutylenbasis (A') das Harz auf Polyisobutylenbasis (B') in einer Menge von 5 bis 55 Massenteilen und das hydrierte Petroleumharz (C') in einer Menge von 10 bis 55 Massenteilen enthält.

6. Klebefolie gemäß Anspruch 5, worin das hydrierte Petroleumharz (C') mindestens eines oder mehrere ausgewählt aus einer Gruppe bestehend aus einem hydrierten Harz eines C5-Petroleumharzes, erhalten durch Copolymerisation einer C5-Fraktion, einem hydrierten Harz eines C9-Petroleumharzes, erhalten durch Copolymerisation einer C9-Fraktion, und einem hydrierten Harz eines copolymerisierten Petroleumharzes einer C5-Fraktion und einer C9-Fraktion ist.

7. Klebefolie gemäß einem der Ansprüche 3 bis 6, worin die Durchlässigkeit des sichtbaren Lichts bei einer Wellenlänge von 550 nm der Klebeschicht mit einer Dicke von 50 µm mindestens 90% beträgt.

8. Klebefolie gemäß einem der Ansprüche 3 bis 7, worin die Feuchtigkeitsdampfdurchlässigkeitsrate der Klebeschicht mit einer Dicke von 50 µm bei 40 °C und einer relativen Feuchtigkeit von 90% höchstens 10 g / m² / Tag beträgt.

9. Klebefolie gemäß einem der Ansprüche 3 bis 8, die eine solche Konfiguration aufweist, daß die Klebeschicht zwischen zwei Trennmaterialien, die kein Substrat verwenden, sandwichartig angeordnet ist.

10. Klebefolie gemäß einem der Ansprüche 3 bis 9, die zum Abdichten von organischen EL-Elementen verwendet wird.

## Revendications

1. Composition adhésive comprenant une résine à base de polyisobutylène (A) ayant un poids moléculaire moyen en poids allant de 270000 à 480000, une résine à base de polyisobutylène (B) ayant un poids moléculaire moyen en poids allant de 100000 à 250000 et une résine de pétrole hydrogénée (C) ayant un point de ramollissement allant de 90 à 135°C ; qui contient, par rapport à 100 parties en masse de la résine à base de polyisobutylène (A) dans celle-ci, la résine à base de polyisobutylène (B) en une quantité allant de 5 à 55 parties en masse et la résine de pétrole hydrogénée (C) en une quantité allant de 10 à 55 parties en masse ;
à condition que la composition soit différente des Exemples de Fabrication D et E du document EP 2 615 144 A1.

2. Composition adhésive selon la revendication 1, dans laquelle la résine de pétrole hydrogénée (C) est au moins une ou plusieurs résine(s) choisie(s) dans un groupe constitué d'une résine hydrogénée d'une résine de pétrole en C₅ obtenue par copolymérisation d'une fraction en C₅, d'une résine hydrogénée d'une résine de pétrole en C₉ obtenue par copolymérisation d'une fraction en C₉, et d'une résine hydrogénée d'une résine de pétrole copolymérisée d'une fraction en C₅ et d'une fraction en C₉.

3. Feuille adhésive ayant une couche adhésive de la composition adhésive de la revendication 1 ou 2.

4. Feuille adhésive ayant au moins une couche adhésive, dans laquelle la couche adhésive est formée d'une composition adhésive qui comprend une résine à base de polyisobutylène (A') ayant un poids moléculaire moyen en poids allant de 270000 à 480000, une résine à base de polyisobutylène (B') ayant un poids moléculaire moyen en poids allant de 100000 à 250000 et une résine de pétrole hydrogénée (C') ayant un point de ramollissement allant de 90 à 135°C,
à condition que la composition soit différente des Exemples de Fabrication D et E du document EP 2 615 144 A1,
et dans laquelle
l'adhérence à l'essai de la couche adhésive, telle que mesurée à une vitesse de pelage de 600 mm/min selon la norme JIS-Z0237 (1991), a deux valeurs maximales et où la première valeur maximale P1 détectée en premier lieu est d'au moins 4,0 N et le rapport de la deuxième valeur maximale P2 détectée en deuxième lieu sur la première valeur maximale P1 [P2/P1] est compris entre 0,25 et 1,50.

5. Feuille adhésive selon la revendication 4, dans laquelle la composition adhésive contient, par rapport à 100 parties en masse de la résine à base de polyisobutylène (A') dans celle-ci, la résine à base de polyisobutylène (B') en une quantité allant de 5 à 55 parties en masse et la résine de pétrole hydrogénée (C') en une quantité allant de 10 à 55 parties en masse.

6. Feuille adhésive selon la revendication 5, dans laquelle la résine de pétrole hydrogénée (C') est au moins une ou plusieurs résine(s) choisie(s) dans un groupe constitué d'une résine hydrogénée d'une résine de pétrole en C₅ obtenue par copolymérisation d'une fraction en C₅, d'une résine hydrogénée d'une résine de pétrole en C₉ obtenue par copolymérisation d'une fraction en C₉ et d'une résine hydrogénée d'une résine de pétrole copolymérisée d'une fraction en C₅ et d'une fraction en C₉.

7. Feuille adhésive selon l'une des revendications 3 à 6, dans laquelle la transmittance de lumière visible à une longueur d'onde de 550 nm de la couche adhésive ayant une épaisseur de 50 µm est d'au moins 90%.

8. Feuille adhésive selon l'une des revendications 3 à 7, dans laquelle le taux de perméabilité à l'humidité à 40°C et à une humidité relative de 90% de la couche adhésive ayant une épaisseur de 50 µm est d'au plus 10 g/m²/jour.

9. Feuille adhésive selon l'une des revendications 3 à 8, qui a une configuration telle que la couche adhésive est prise en tenaille entre deux matériaux antiadhésifs sans utiliser un substrat.

10. Feuille adhésive selon l'une des revendications 3 à 9, qui est utilisée pour sceller des éléments électroluminescents (EL) organiques.
